# EUROPEAN PATENT APPLICATION

(11) **EP 1 168 464 A1**
(43) Date of publication of application: **02.01.2002**
(21) Application number: 00909748.6
(22) Date of filing: 17.03.2000
(51) Int. Cl.: H01L 41/08, H01L 41/22, H03H 9/19

(54) **PIEZOELECTRIC ELEMENT AND PRODUCTION METHOD THEREFOR**

(30) Priority: 19.03.1999 JP 11695799; 12.04.1999 JP 14055799; 09.10.1999 JP 32449299; 09.10.1999 JP 32449399
(71) Applicant: Nagaura, Yoshiaki, Chikushino-shi, Fukuoka 818-0053 (JP)
(72) Inventor: Nagaura, Yoshiaki, Chikushino-shi, Fukuoka 818-0053 (JP)
(74) Representative: Goddar, Heinz J., Dr.
(86) International application number: JP0001691
(87) International publication number: WO0057494

(57) **Abstract**

The objective of present invention is introduce machining tools and to manufacturing method to make extremely thin electronic material such as a piezoelectric element as a quartz oscillator, silicone or Gallium Arsenic and so on as well as a optical lens, which were difficult to be machined by conventional techniques.

The manufacturing process of piezoelectric element and silicone and so forth is featuring to make plural concave parts on the surface of the piezoelectric blank (80 µm thick and 2 inch diameter for example), which is machined by lapping tools as dual faced, one faced or others, is lapped by using the conventional chemical etching method as the first step, and to make thinner typically 12 µm (to 62 µm for example) on another surface of the blank by the reactive ion etching (RIE) as the second step. Finally both surfaces are lapped by the dual-face mechanical lapping machine, one face machine or float polishing machine in order not only to eliminate the rough ion-damaged layer in a few µm thickness (for example convex and concave surface exists in thickness from 0.2 µm to 3 µm due to RIE) after the chemical RIE process, dry etching as ion milling and plasma etching or wet etching, but also to form the oscillating part in a convex lens shape at the opposite surface of concave part.

## Description

### Technical Field

The present invention is related to a piezoelectric element and a manufacturing method, which is greatly capable to enhance the fundamental oscillation frequency.

### Related Art

A quartz oscillator, which is one of piezoelectric element, can apply to a wide variety of devices such as standard frequency sources of communication equipment and detection instrumentation, general purpose computers, OA information apparatus, micro computer clock pulses of home electric appliances and so forth. Therefore, the fundamental oscillation frequency is required to be enhanced by making the thickness thinner in order to get the higher performance of the information processing and the transmitting capability.

Also, the novel shape is proposed to shape the element in lens configuration in order to manufacture the high quality oscillator, and the element has achieved the high performance relatively in lower frequency zone.

However, there exists a problem to thinner the oscillator, and the dual-face lapping machine could make it only down to 24.0 µm (approximately 70 MHz resonance). Also when the lens shape piece could not be made up, since the curve face was extremely difficult to manufacture.

Furthermore, although conventional detection and prediction methods of earthquake were the underground structure probe techniques for ocean observation, oil, methane gas, gold, silver and diamond, otherwise earth magnetic field detection, GPS survey or laser scan between tow distances, the air vibration detection of the earthquake and Tsunami may be one of promising candidates. The sound collection microphone was used to change the air vibration to the electric signal to record and analyze it easily, however it is too difficult for this microphone to detect the specific frequency, since this can frequently pick up noises.

Quartz oscillators are essential electronic devices for digital equipment for communications and computers. The oscillator is required to increase the fundamental frequency by thinner the element for the higher performance of the information processing and the transmitting speed. Furthermore for mobile communication equipment, the primary frequency should be higher to make them smaller and to save the electric power.

The manufacturing methods of Quartz oscillator were generally the mechanical polishing and chemical wet etching. The former could make oscillator in various surface shape, however the minimum thickness was 30 µm. The latter could made thinner in principle without the surface processing damage, but this process also had the limitation to be thinner with the etch channel and so on. On the other hand, a reactive ion etching (RIE) or plasma etching (these are called as the chemical dry etching) would introduce the ion-damaged surface, however the dry etching will be capable to make the oscillator thinner without the surface roughness.

The mass production process is developed to employ these advantageous methods for high frequency quartz oscillators. However as the thinner oscillator, the conventional manufacturing method with dual-face lapping machine had the limitation at 30 µm (frequency 55.6 MHz). Furthermore in case of finishing the surface in a lens shape, the manufacturing was extremely difficult to make the surface in curved shape on the thinner element, and there existed no means to mass-produce thinner oscillators at a reasonable cost.

### Disclosure of Invention

Therefore, the first object of the present invention is both to introduce the piezoelectric element, which thickness is thinner than any other one, and to disclose the manufacturing process. The second object is to introduce a sound to electric transducer, accurately to detect the sound wave of the specific frequency with the minimum noise. The manufacturing process of piezoelectric element in the present invention to solve the above problems is featuring to make a concave part on one surface of plate by using the chemical etching method, and to make thinner on the other surface by the reactive ion etching, and to polish the both surfaces of the element by the mechanical lapping in order not only to eliminate the rough layer due to RIE but also to form the oscillating part in a convex lens shape at the concave part.

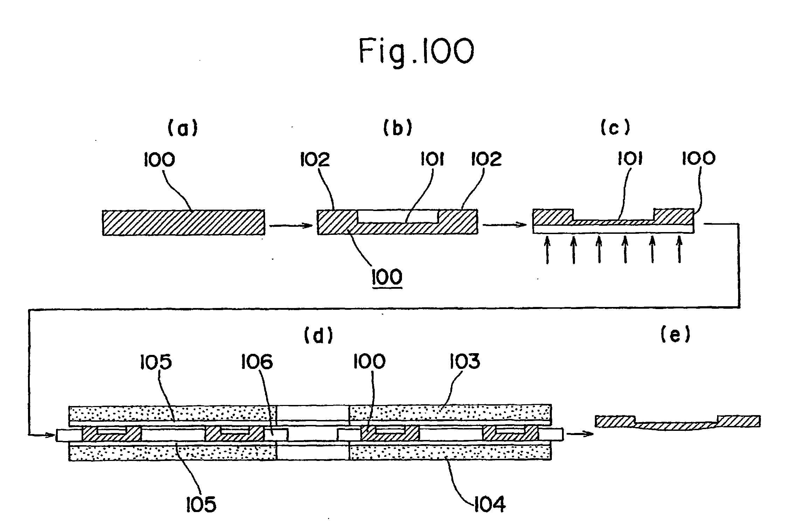

Figure 100 shows the manufacturing process of the present invention. First of all, a quartz blank plate 100 which thickness is 50 µm for example is cut from an artificial quartz blank 100 (Figure 100 (a)), and a concave part 101 in the cross section is formed by resolving the one surface (the central part of upper side) of said plate by a chemical etching method with fluorine hydride (Figure 100 (b)). The thinner part from the base surface of the concave part 101 to the lower surface of the quartz blank 100 is the oscillating part, which generates high frequency, and remaining part is a frame part 102. This is in the same way of the conventional manufacturing process.

As the next stage, the lower whole surface of the quartz blank 100 was etched by ion etching process with fluorine gas, and the plate becomes thinner (Figure 100(c)). The ion etching is a manufacturing method, where atoms of fluorine ionized gas in the plasma state, are accelerated by electric voltage and collided to the blank 100, and silicone atoms in SiO₂ are etched from the surface.

The chemical etching alone cannot machine the plate thinner than 20 µm as mentioned above. Afterward the plate will become thinner down to 10.3 µm approximately with ion etching process. However even ion etching cannot attain the 10 µm target. Although the ion etching makes the Plate thinner, this process is found to make "ion-damaged layer", which is non-crystalline part and unknown defect formed by atom collisions at the single crystalline surface. The thickness of this layer is from 0.2 µm to 0.3 µm.

The mechanical lapping is to be consequently employed. The final dual-face surface polishing (Figure 100 (d)) will be executed at the lapping layer of approximately 0.3 µm. This dual lapping machine is a similar construction of gear mechanism like a planet. First of all the quartz plate 100 is set in a steel-made carrier 106 (planet gear) which rotates round its axis and revolves around a fixed point, and the plate is set between an upper ground table 103 and the lower table 104. Two polyurethane lapping pads 105 are pasted on the two ground tables.

While cerium oxide powders in water are filled, the quartz plate 100, which is fixed by the carrier 106, rotates and also revolves between the ground tables 101, 104, and both surfaces of the plate 100 are to be polished.

As shown in Figure 100 (e), the shape of quartz plate 100 after the dual-face lapping process is similar to a convex lens which lower surface is in a convex curve. An oscillator in this shape of lens like cross section is known to eliminate higher order oscillations (spurious frequency), which are harmful to electronics, and also to show a stable performance.

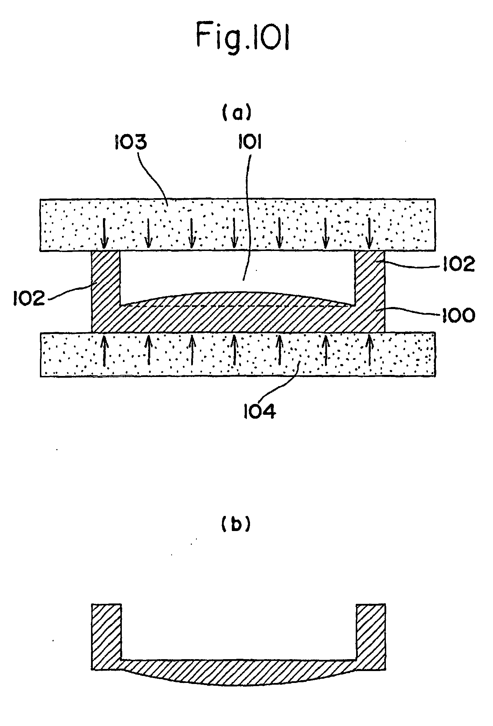

Figure 101 shows the reason why the plate becomes the convex lens shape. The lapped mass is proportional to the lapping pressure. Although the frame part 102 of the concave quartz plate 100 after the ion etching receives extremely high lapping pressure between the upper and lower ground tables 103 and 104, the concave part 101 which becomes the oscillating part receives small lapping pressure only by the lower ground table 104. Furthermore the lapping pressure becomes lower at the central part of the concave plate 101 since the shape is concave (Figure 101 (a)). Therefore the lapped mass becomes minimum at the center of the concave part 101, it is maximum near the frame part 102, and the lapping quantity between the center and frame changes as a spherical part with a certain curvature. As the consequence the quartz oscillator becomes the convex lens shape (Figure 101 (b)). The central part of the lens is most thick as 10 µm.

As understand well, only 0.3 µm layer is lapped by the dual-face lapping process. The small lapping process eliminates the damaged layer and forms the convex lens. Actually the chemical and ion etchings are the coarse lapping, and the dual-face lapping is the fine finishing process.

The present invention with these technology combinations enables piezoelectric element to be the thinnest among conventional processes, and more stable oscillation without spurious frequency is achieved by the oscillation part in the convex lens shape.

In order to achieve the second object, the sound to electric transducer has the pressure detection surface of piezoelectric effect material in the center of the cylinder. The pressure detector has a pair of electrode.

Also the manufacturing method of the sound to electric transducer in the present invention is to machine two cylindrical holes from both ends of the piezoelectric material by using the specific drilling means, and to make the pressure detection surface of the required thickness at the center of the circular rod, and to transfer the signal of the exterior sound vibration by a pair of electrode at the pressure sensor. The machining means are to make grooves at the surface of barrel whetstone, and to rotate the whetstone either by injecting compressed air and liquid, or by using other techniques. Also the barrel stone can be made by steel sphere which cross section is near circle.

### Brief Description of Drawings

Figure 1 is the flow chart of the manufacturing process in the present invention.

Figure 2 is the first manufacturing example of Quartz oscillator, and (a), (b) and (c) shows the cross section of the Quartz oscillator, the microgram of the resonator and the reactance-frequency diagram, respectively. The blank material is AT cut, the thickness is 103 µm, the diameter is 5 mm, the machined dimension is 25 µm, the curvature radius is 30 mm.

Figure 3 is the second manufacturing example of quartz oscillator, and (a) and (b) shows the cross section of the quartz oscillator and the reactance-frequency diagram, respectively. The blank material is AT cut, the thickness is 103 µm, the diameter is 5 µm, the machined dimension is 9 µm, the curvature radius is 200 mm.

Figure 4 is the third manufacturing example of Quartz oscillator, and (a) and (b) shows the cross section of the quartz oscillator and the reactance-frequency diagram, respectively. The blank material is AT cut, the thickness is 77 µm, the diameter is 5 mm, the machined dimension is 27 µm.

Figure 5 is the reactance-frequency diagram of AT cut blank and thick quartz oscillator.

Figure 6 is the reactance-frequency diagram of AT cut blank and thick quartz oscillator.

Figure 7 is the reactance-frequency diagram of AT cut blank and thin quartz oscillator.

Figure 8 is the reactance-frequency diagram of AT cut blank and thin quartz oscillator.

Figure 9 is the reactance-frequency diagram of AT cut blank and more thin quartz oscillator.

Figure 10 is the reactance-frequency diagram of AT cut blank and thinner quartz oscillator.

Figure 11 is a cross section of the first machining supporter in the present invention of the manufacturing method.

Figure 12 is a cross section of the second machining supporter in the present invention of the manufacturing method.

Figure 13 is the set cross section of the first machining supporter, the second supporter and quartz plate.

Figure 14 is a cross section of another example for the present invention of the manufacturing method.

Figure 15 is the cross section and the plan of one manufacturing method for the present invention.

Figure 16 is the cross section of the present manufacturing setup between the lapping plate.

Figure 17 is the plan diagram of another machining supporter for the present invention of the manufacturing setup.

Figure 18 is the cross section of the quartz plate, which is manufactured by the machining supporter in Figure 13.

Figure 19 is the cross section of the quartz plate, which is manufactured by the machining supporter in Figure 13.

Figure 20 is the plan diagram of the lapping plate motion.

Figure 21 is the plan diagram of the lapping plate motion.

Figure 22 is the cross section diagram of an executed example in the present invention.

Figure 23 is the cross section diagram of an executed example in the present invention.

Figure 24 is the cross section diagram of an executed example in the present invention.

Figure 25 is the cross section diagram of the machining setup example in the present invention.

Figure 26 is the cross section of quartz plate manufactured by the setup in Figure 25 and others.

Figure 27 is the cross section of another example of the machining setup.

Figure 28 is the cross section of another example of the machining setup.

Figure 29 is the cross section of another example of the machining setup.

Figure 30 is the cross section of the executed example in the present invention.

Figure 31 is the cross section of the executed example in the present invention.

Figure 32 is the cross section diagram of the machining method in the present manufacturing invention.

Figure 33 is the side view diagram of the machining tool in the present manufacturing invention.

Figure 34 is the side view and A-A cross section diagram of the machining stone in the present manufacturing invention.

Figure 35 is the cross section diagram of one example executed for the present manufacturing invention.

Figure 36 is the side view and cross section diagram of another machining stone in the present manufacturing invention.

Figure 37 is the cross section diagram of another machining tool in the present manufacturing invention.

Figure 38 is the cross section diagram of another machining tool in the present manufacturing invention.

Figure 39 is the cross section diagram of another machining tool in the present manufacturing invention.

Figure 40 is the side view and plan diagram of the machining tool for the actual manufacturing diagram in the present invention.

Figure 41 is the enlarged cross section and plan diagram of the machining tool for the actual manufacturing diagram in the present invention.

Figure 42 is the cross section of the manufactured sample the present invention.

Figure 43 is the cross section of the manufactured sample the present invention.

Figure 44 is the cross section of the quartz plate manufactured by the machining supporter in Figure 13.

Figure 45 is the cross section of the quartz plate manufactured by the machining supporter in Figure 13.

Figure 46 is the cross section of the quartz plate manufactured by the machining supporter in Figure 14.

Figure 47 is the cross section of the sample manufactured by the present invention.

Figure 48 is the cross section of the sample manufactured by the present invention.

Figure 49 is the cross section of the sample manufactured by the present invention.

Figure 50 is the cross section of the sample manufactured by the present invention.

Figure 51 is the cross section of the sample manufactured by the present invention.

Figure 52 is the cross section of the sample manufactured by the present invention.

Figure 53 is the cross section of the sample manufactured by the present invention.

Figure 54 is the cross section of the sample manufactured by the present invention.

Figure 55 is the cross section of the sample manufactured by the present invention.

Figure 56 is the cross section of the sample manufactured by the present invention.

Figure 57 is the reactance-frequency diagram of the thin quartz oscillator of AT cut material.

Figure 58 is the reactance-frequency diagram of the thinner quartz oscillator of AT cut material.

Figure 59 is the reactance-frequency diagram of the thinner quartz oscillator of AT cut material.

Figure 60 is the reactance-frequency diagram of the thinnest quartz oscillator of AT cut material.

Figure 61 is the cross section and plan diagram to show the machining method of the present invention.

Figure 62 is the cross section diagram to show the machining method of the present invention.

Figure 63 is the cross section diagram to show the machining method of the present invention.

Figure 64 is the cross section diagram to show the machining method of the present invention.

Figure 65 is the cross section and plan diagram to show the machining method of the present invention.

Figure 66 is the cross section and plan diagram to show the machining method of the present invention.

Figure 67 is the cross section and plan diagram to show the machining method of the present invention.

Figure 68 is the cross section and plan diagram to show the machining method of the present invention.

Figure 69 is the cross section and plan diagram to show the machining method of the present invention.

Figure 70 is the cross section and plan diagram to show the machining method of the present invention.

Figure 71 is the cross section diagram to show the machining method of the present invention.

Figure 72 is the cross section diagram to show the machining method of the present invention.

Figure 73 is the cross section diagram to show the machining method of the present invention.

Figure 74 is the cross section diagram to show the machining method of the present invention.

Figure 75 is the measured upper surface shape diagram of the AT cut quartz oscillator in the concave lens shape.

Figure 76 is the measured rear surface shape diagram of the AT cut quartz oscillator in the concave lens shape.

Figure 77 is the reactance-frequency diagram of the AT cut quartz plate in the concave lens shape, which is made by wet etching process.

Figure 78 is the reactance-frequency diagram of the AT cut quartz plate in the concave lens shape, which is made by the mechanical lapping means after the wet etching process.

Figure 79 is the cross section diagram to show the manufacturing method of the present invention.

Figure 80 is the cross section diagram to show the manufacturing method of the present invention.

Figure 81 is the cross section diagram to show the manufacturing method of the present invention.

Figure 82 is the cross section diagram to show the manufacturing method of the present invention.

Figure 83 is the cross section diagram to show the manufacturing method of the present invention.

Figure 84 is the reactance-frequency diagram of the AT cut quartz plate in the concave lens shape which is made by the mechanical lapping means after the wet etching process.

Figure 85 is the reactance-frequency diagram of the AT cut quartz plate in the concave lens shape which is made by the mechanical lapping means after the wet etching process.

Figure 86 is the reactance-frequency diagram of the AT cut quartz plate in the concave lens shape which is made by the mechanical lapping means after the wet etching process.

Figure 87 is the measured upper surface shape diagram of the AT cut quartz oscillator in the concave lens shape

Figure 88 is the measured upper surface shape diagram of the AT cut quartz oscillator in the concave lens shape

Figure 89 is the cross section diagram to show the manufacturing method of the present invention.

Figure 90 is the cross section diagram to show the manufacturing method of the present invention.

Figure 91 is the cross section diagram to show the manufacturing method of the present invention.

Figure 92 is the cross section diagram to show the manufacturing method of the present invention

Figure 93 is the reactance-frequency characteristics of thick quartz oscillator which material is AT cut, and the plan the cross section of the resonator of the single inverted mesa type.

Figure 94 is the reactance-frequency characteristics of thin quartz oscillator.

Figure 95 is the shape diagram of thin quartz oscillator, which is measured by the interference microscope.

Figure 96 is the reactance-frequency characteristics of thin quartz oscillator which material is AT cut.

Figure 97 is a peak to valley (P-V) diagram.

Figure 98 is a graph of inverted curvature radius in the convex lens shape of single inverted mesa type.

Figure 99 is a graph of the surface roughness change at the concave center of single inverted mesa type.

Figure 100 is the flow diagram of the manufacturing process for the present invention.

Figure 101 describes the formation mechanism of the piezoelectric convex lens for the present invention.

### EMBODIMENT OF Invention

This chapter presents the embodiments carrying out our invention.
The present inventors succeeded to develop novel machining method in a field of lapping machine and to make quartz oscillators which thickness is 9 µm and shape is plano-convex. Furthermore, relations between the thickness and the electric characteristics of oscillators, which were thinner than 500 µm, were surveyed in order to develop the higher performance quartz oscillators.
As quartz is fragile, the matched machining method was thought to be limited to the mechanical lapping or chemical wet etching. Therefore, the lapping machining method was seldom used to make quartz oscillators for high frequency use.

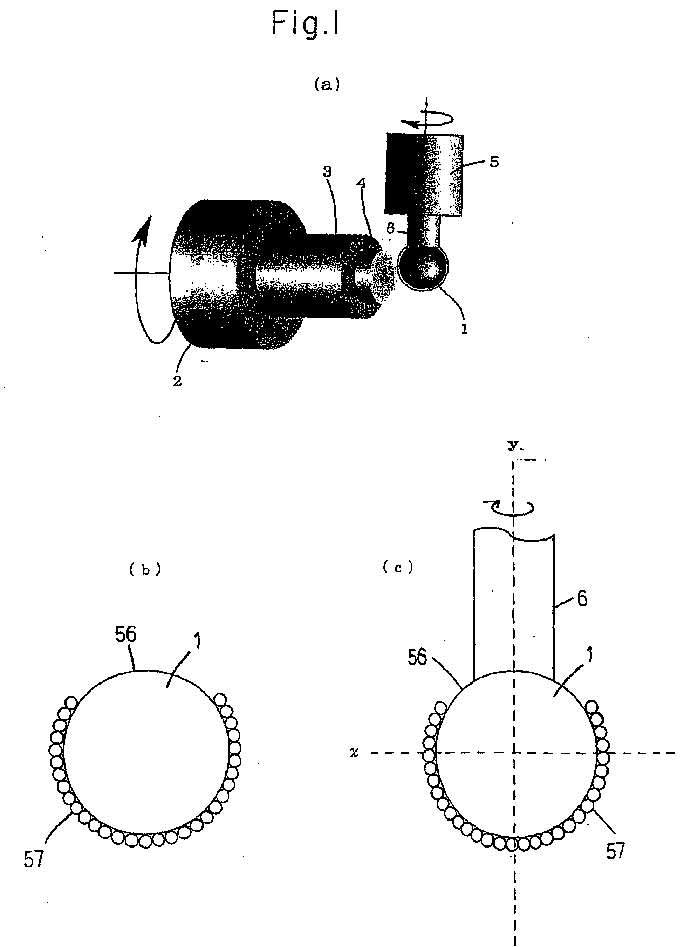

The lapping method invented by the present authors uses a ball whetstone 1, which steel sphere is gilt by diamond grinding grains 57 as shown in Figure 1. In other words, the quartz plate 4 is set on a cylindrical magnet 3, which is set on the primary axis of ultra high precision lathe, and the tool supporter 6 with a sphere stand is mounted at the end of the grinding spindle 5. When this is accessed to the cylindrical magnet 3, the steel sphere is attracted to the tool supporter 6 by the magnetic induction. Since the tool supporter 6 is smaller than the diameter of cylindrical magnet 3, the magnetic flux between the ball whetstone 1 and the tool supporter 6 is stronger than that between the ball whetstone 1 and the cylindrical magnet 3. Therefore the ball whetstone 1 is strongly attracted to the tool supporter 6, and they are one-body without the separation even if during the high frequency rotation.

The present lapping method employs a ball whetstone 1 which is gilt electrically by diamond grains 57 on the steel sphere. Also the centering of the whetstone 1 becomes unnecessary during the exchange, since the tool holder 6 is cylindrical and the steel sphere is accurately made. Therefore the exchange of the whetstone 1 becomes speedy from the rough machining to the final lapping. This motion of the ball whetstone 1 is controlled by NC machine, and the curved surface can be also made.

The diameter of diamond whetstone grain 57, which is electrically gilt on the ball whetstone 1 of steel sphere for ball bearing and so on, is various and is for example 30 µm for the rough machining, 16 µm for the middle one and 4 mm for the fine one, respectively. Since the diameter of diamond whetstone grain 57 depends on the machining stage, the central point of the ball whetstone 1 moves perpendicularly along the diameter of the whetstone grain 57, when the ball whetstone 1 is absorbingly hold to the cylindrical holder 6 by the magnetic induction of the cylindrical magnet 3 at the primary axis 2.

As shown in Figure 1 (b) the solution to this problem is only for the area of the cylindrical holder 56 at the ball whetstone 1, which is set by the tool holder 6, not to be contacted to the diamond grain 57. Then the ball whetstone 1, which is either for the rough lapping, for the middle one or for the final one, can be easily changed for any diameter of diamond whetstone grain 57, since the central line of the x and y axes for the ball whetstone 1 are fixed especially as for the perpendicular axis x as shown in Fig. 1 (c).

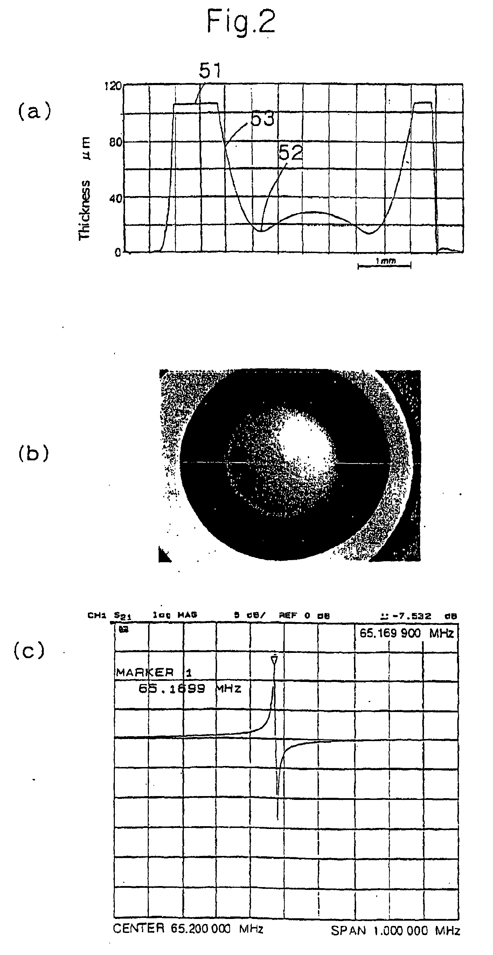

The present inventors succeeded to make the plano-convex shape oscillator which holder 51 is combined to the groove 52 as shown in Figure 2 (a). It is called as the smooth line 53 to combine the holder 51 and the groove 52. The lens shape is 25 µm thick, 3 mm curvature radius and the shaping error less than 0.1 µm as shown in Figure 2 (b) where the central part of quartz disk is machined. Conventionally the quartz resonator in this shape was thought to be spuriously vibrated and in poor performance. However as seen in Figure 2 (c), the reactance-frequency characteristics is steeply resonated without any spurious signal, and this is understood as an ideal quartz oscillator.

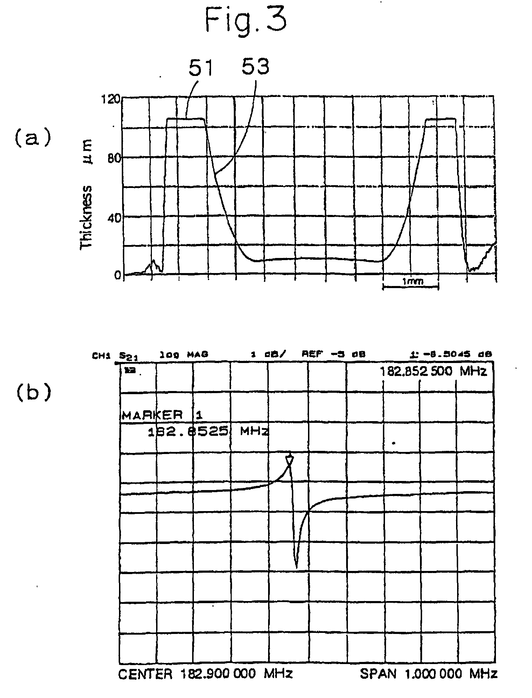

Further trial to make thinner quartz resonators brought a success to manufacture 9 µm thick and 200 mm curvature radius oscillators. After this was lapped by cerium oxide and eliminated the surface of approximately 0.5 µm thickness, we got the product as shown in Figure 3 (a). Figure 3 (b) shows the reactance-frequency property, which curve is no so steep and the Q value is slightly smaller than that in Figure 2, however there is utterly no spurious oscillation. The reason why the curve is no so sharp is that there exists a damaged layer inside the surface of the resonator, and that the relative ratio of the layer becomes larger in thinner quartz. However, this damaged layer can be improved by the additional etching process.

The next stage was tried to increase the thickness of quartz lens for a condition of the constant curvature radius as 30 mm. When the thickness was less than 125 µm, there was a sharp resonance without the spurious oscillation as seen in Figure 2. However, new phenomena appeared to be spurious or to be not resonated, when the thickness is over 125 µm.

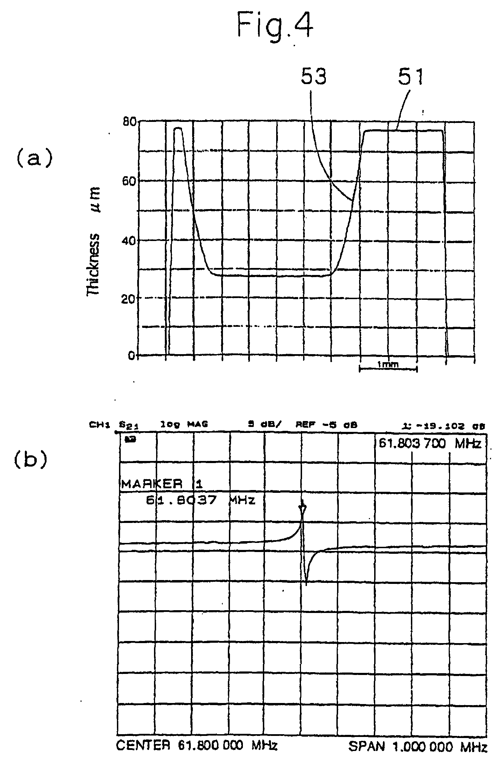

On the other hand we made quartz oscillators which were 27 µm thick and in the planar or concave lens shape called as the inverted mesa type as shown in Figure 4 (a). Figure 4 (b) shows the electric characteristics, which is slightly poor than that of the plano-convex type, however there was no spurious signal. Also as the thickness of the inverted mesa type resonator was increased, there was no oscillation over 30 µm thickness. Since the inverted mesa type is thought to be the plano-convex lens with the infinite diameter, this quartz oscillator with the ring support has the good resonance or non-resonance region, which depends on the thickness of the oscillating part.

This invented method introduced the following conclusions. Although the quartz oscillator with no spurious signal was thought to be conventionally bi-convex, the plano-convex type quartz can also show the ideal resonance without the spurious oscillation when the thickness is less than approximately 30 µm. Also the manufacturing technique of plano-convex type in Figure 1 can be applied to the concavo-convex or bi-convex type.

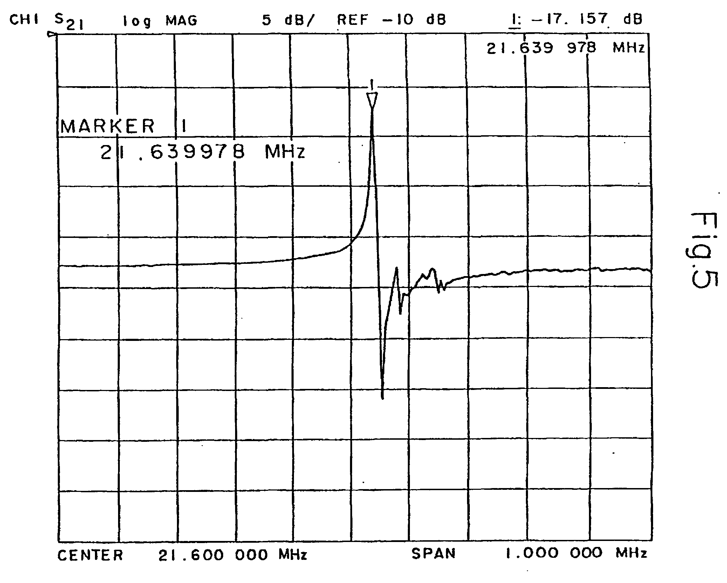

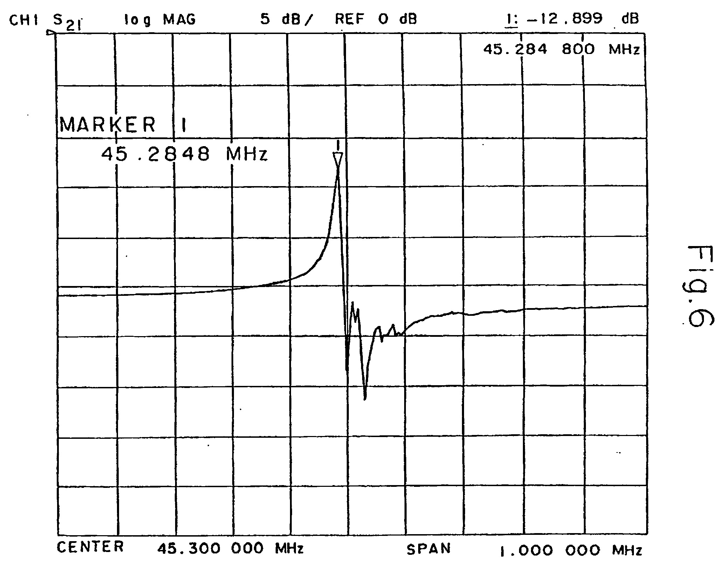

The present inventors devoted their efforts the research of quartz resonator as thin as possible. Figure 5 and Figure 6 show the reactance-frequency characteristics of respectively 76. 7 µm and 100 µm thickness with 5 mm diameter.

In this Figure there are spurious signals near the fundamental oscillation.

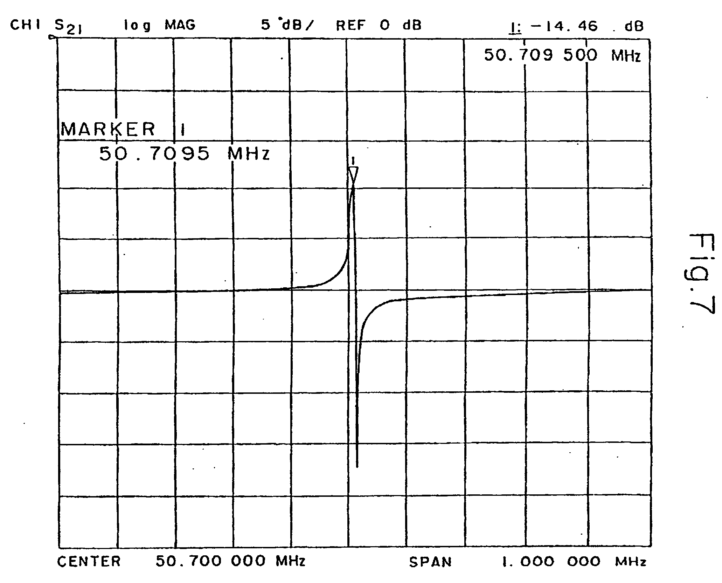

Figure 7 shows the reactance-frequency curve of 33µm quartz oscillator, and there is no spurious peak within 5 MHz of the fundamental frequency.

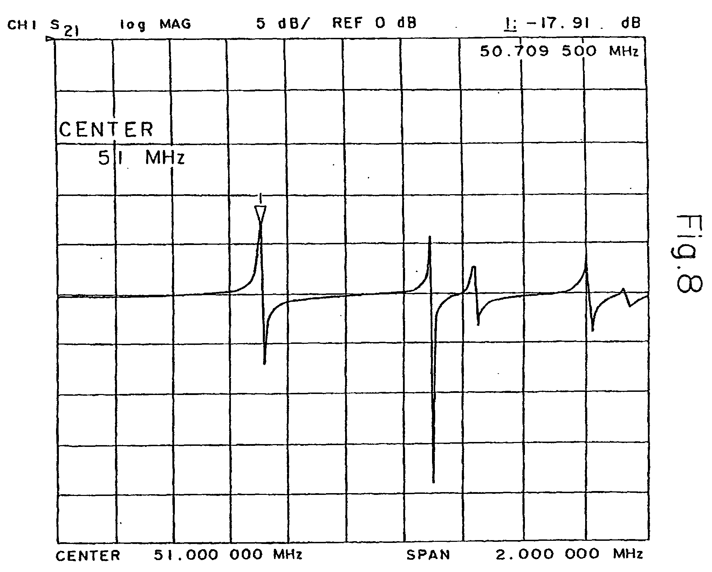

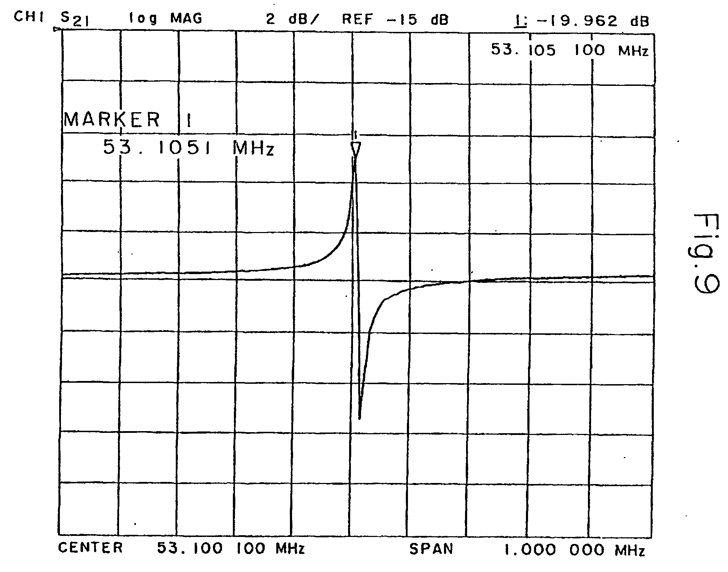

Figure 8 shows many spurious signals in 6 MHz intervals approximately. Figure 9 is the reactance-frequency property of 31 µm thick quartz oscillator, and no spurious peak is seen within 5 MHz of the fundamental frequency, but the spurious signal is approximately 8 MHz apart from the fundamental one as shown in Figure 10. Then the thinner the quartz oscillator is, the farther the spurious signal from the primary oscillation.

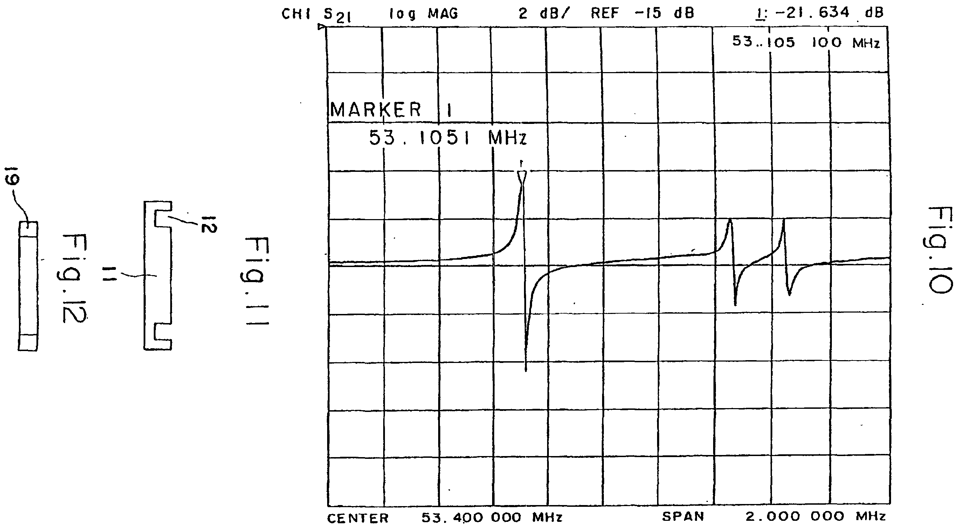

From Figure 11 to Figure 19, the manufacturing system of the quartz oscillator is presented. This system has the groove or step 12 in ring, rectangular or other shapes as shown in Figure 11. This groove or ring 12 is inserted by the second machining auxiliary tool 19, which is in ring, other ring shapes or cylindrical shape deeper than the ring or groove 12. The lapping object as quartz oscillator 13 in this case is set inside the second machining auxiliary tool 19. This quartz oscillator is as high as the protruding height (for example 40 µm) of the second tool 19 from the first tool 11, and the shape of the oscillator 13 is disk or others.

As other lapping procedures the following methods are convenient to correct the distortion during machining the quartz oscillator 13.
(1) Before the oscillator 13 is set on the first auxiliary tool 11, the one surface is evaporated by metals as gold, silver or aluminum etc as the preprocessing.
(2) After one side of oscillator 13 has the metal membrane or other processes are used, the surface of one side is processed so as to discriminate the front from the rear surface.
(3) Then for instance when the very thin metal membrane is made, the oscillator 13 is set on the first tool 11, and the plate 13 is lapped to 20 µm thick for example after this is lapped to be 40 µm by the dual face lapping machine.
(4) Even during the lapping process, the lapped surface of the plate 13 has substantial distortion. In order to eliminate the distortion, the washing is required for the first tool 11, the second tool 19 and the plate 13 after these are took off from the dual face lapping machine.
(5) Then the surface of metal membrane on the plate 13 is set upwards again, the plate 13 during the lapping is set on the first tool 11, this plate 13 is lapped from the surface of the metal membrane, and the final plate 13 is made to be 10 µm thick approximately. At the same time since the plate 13 is lapped from both sides, the distortion is limited to be minimum when the plate 13 is lapped from one side.

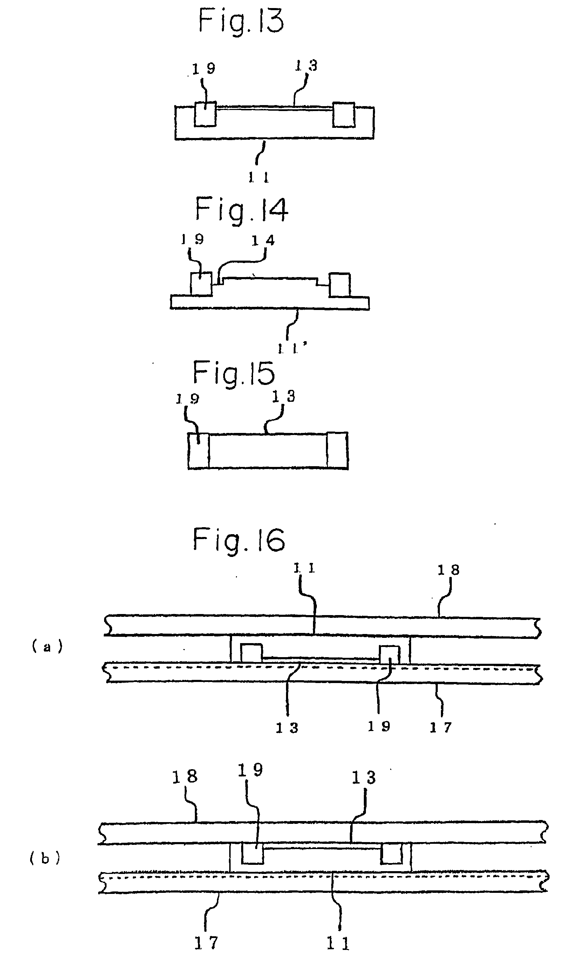

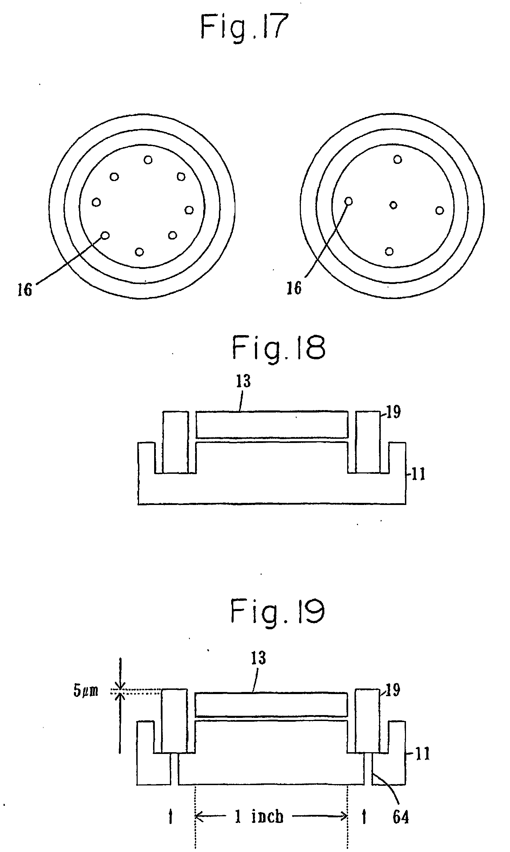

Another example in Figure 15 shows the lapping process of the Quartz plate 13 only with the second auxiliary tool 19 without the first tool 11. Also as seen as an another case in Figure 7 (a) (b), plural holes 16 are made in the first tool 11. The number of holes 16 is 2 or 3, and the quartz plate 13 is connected to the first tool 11 only at the area of holes 16 after the holes 16 are filled with the viscous material as honey, a bond or grease of adhesive 59 or other adhesives. The plate 13 can also sucked by the vacuum force through the holes 16. The hole 16 locate at the circumferential region as shown in Figure 17(a), or they are set coaxially as Figure 17 (b), but these are not all cases. When the quartz plate 13 is connected by the holes 16 of the first tool 11 only at the small area of holes 16, the second tool 19 is not always used.

When the quartz plate 13 is used to be absorbed to the upper surface of the first auxiliary tool 11, the one face lapping machine is employed, since the dual faced lapping machine is not used. However it is omitted to show the structure diagram of the upper tool surface 11 to be connected.

Figure 18 and Figure 19 show the shape of the quartz plate 13, which is lapped by the first lapping tool 11 and the second tool 19 as seen in Figure 13. It is the reason why the shape of the plate 13 in Figure 18 is different from that in Figure 19 that the material of the second tool 19 is different between Figure 18 and Figure 19. This is applicable only to the case of the lapping plate 17 and 18, which is made of the suede (pad or buff), and the shape in Figure 18 becomes identical to that in Figure 19 when the lapping plates 17 and 18 are made from iron, tin and so forth. However the lapping agent 65 for the lapping plate of tin should be made from cerium oxide, diamond or GC etc.

The second tool 19 in Figure 18 is made from hard glass of quartzite which hardness is same as the quartz plate 13, and the tool 19 in Figure 19 is made from hard metal as super steel or iron or fro plastic which is more difficult to be machined than the quartz plate 13. The lapping agent 65 must be cerium oxide, since the quartz plate 13 can be well lapped by the agent 65 due to the quartz similarity of quartzite as hard glass, however the second tool 19 made from hard metal as super steel or iron is too hard to be lapped by the agent 65.

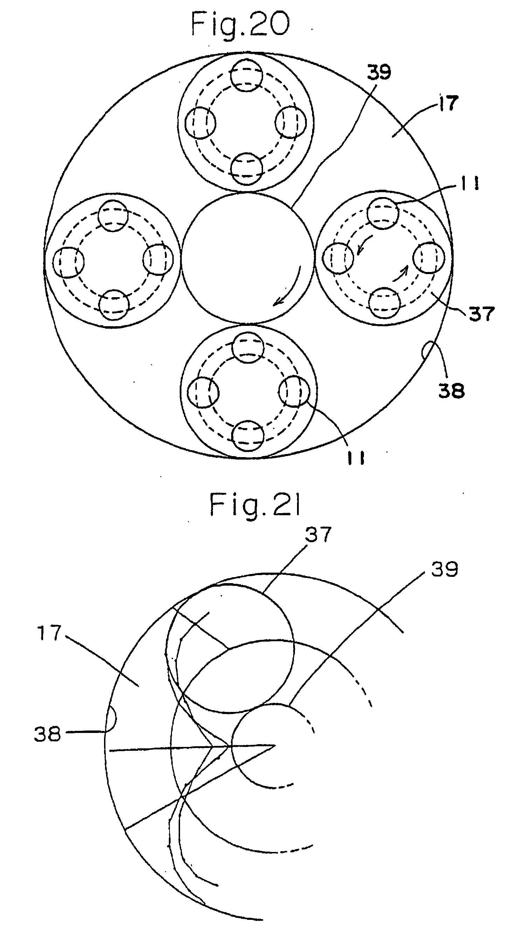

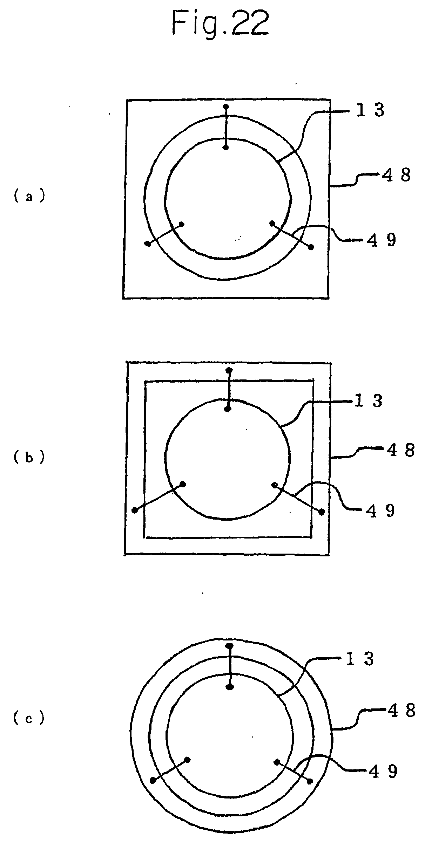

As shown in Figure 20 and Figure 21, the upper and lower lapping plate 17 and 18 revolves with the supply of slurry (moving whetstone grains), the quite thin quartz plate 13 can be lapped easily. When the carrier 37 of the first lapping auxiliary tool 11 is set between the sun gear 39 and the internal gear 38 and the first tool 11 revolve around the sun gear 39 and also rotate itself, which is known as the planet motion, the extremely thin quartz oscillator is easily lapped, while the upper surface of quartz plate 13, which is held by one surface of the first tool 11 machined by the upper lapping plate 18, and another surface of the quartz plate 13 is machined by the lower lapping plate 17 as shown in Figure 16 (b). In case of one side lapping method, the same technique is used to lap the quartz plate 13.

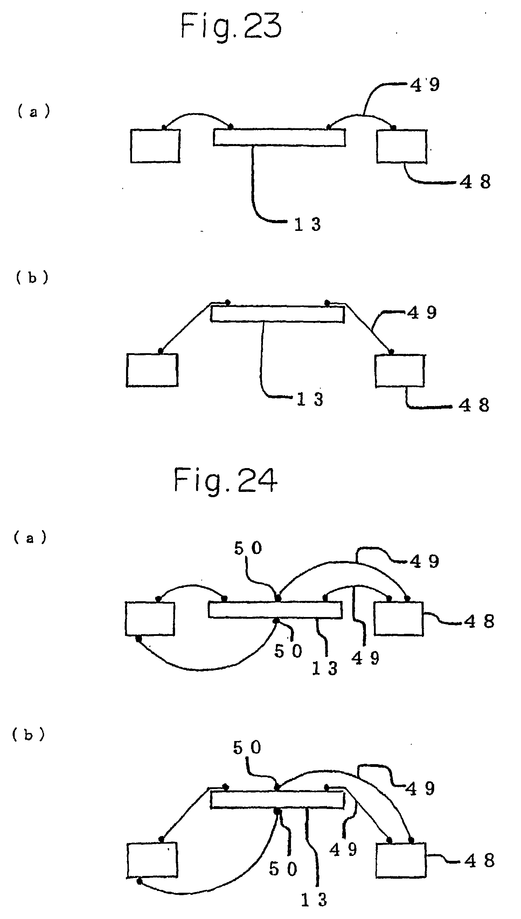

After the Quartz plate 13 is machined to be extremely thin as 10 µm for example by the above techniques, it becomes very difficult for the thin plate 13 to be handled and also to set the electrode of the plate 13. Then as shown in Figure 22, the quartz plate 13 is set at the center of the holding frame 48, which is made from an isolator or a non-isolator, the plate 13 is held to the frame 48 by a fine gold wire 49 (for example 18 µm) with the bonding machine. After the quartz plate 13 is set to the frame 48, it is still better for the whole surface of the plate 13 to be pushed upwards, otherwise for the gold wire 49 to be tightened by other means as seen Figure 23 (b), since the wire 48 is loose as shown in Figure 23 (a). As shown in Figure 23 when the quartz plate 13 is fixed to the frame 48 by the wire 49 from three directions at least as shown in Figure 22, the vibration of the plate 13 is absorbed by the wire 49 and the quartz property is enhanced to the uttermost degree, since the plate 13 becomes the state of floating as if in the air.

After the quartz plate 13 is set to the frame 48 by the wire 49 as seen Figure 23, the electrode 50 is deposited to the small central part of the plate 13 by gold and so on, and electrodes at both surfaces are connected to the gold wire 49 by the bonding machine as shown in Figure 24. Then electrodes 50 are set only at the center of the plate 13 by the fine gold wire 49 (approximately 18 µm), and the quartz property does not deteriorated as the conventional electrodes (for example the evaporated ones at the whole quartz plate).

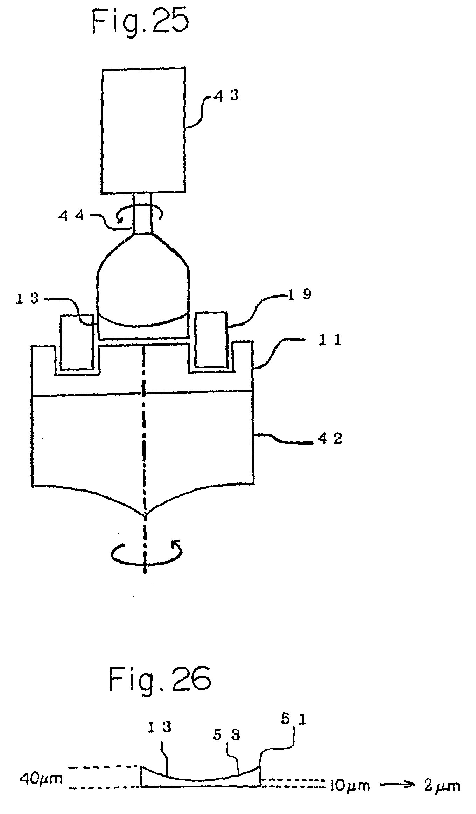

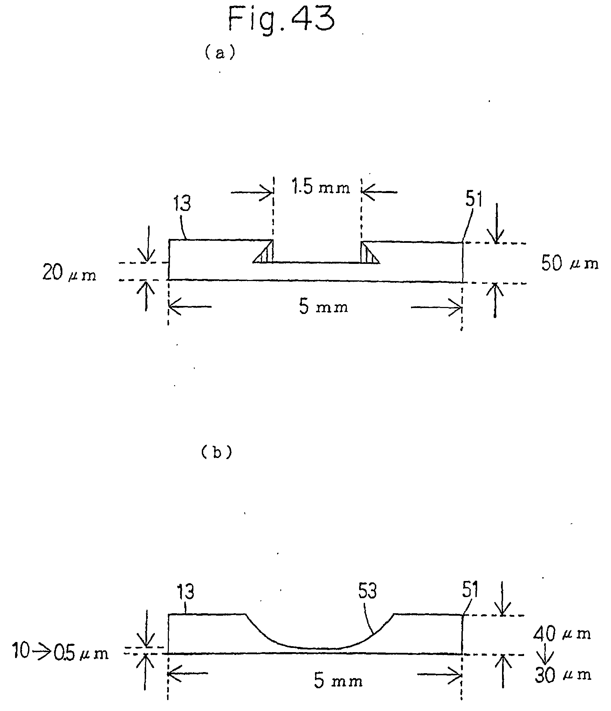

Figure 25 shows the manufacturing system of concave quartz oscillator 13 at one side. In Figure 25, the number 11 is the first lapping auxiliary tool, 19 is the second lapping auxiliary tool, 41 is a motor to rotate these tools 11 and 19 at a low speed (foe example from 100 to 300 rpm), 43 is a motor to rotate a lapping tool 44 at a high speed (for example 5000 rpm). The lapping tool 44 is made from soft material as felt, cotton stick, buff etc., this tool laps approximately at 1 mm/min by cerium oxide, GC or diamond grains and so forth. As seen in Figure 26, the quartz plate 13 of approximately 40 µm thickness is finished to the plate 13 of the central 2 ∼10 µm thickness. Also Figure 25 shows the manufacturing system of quartz plate 13 in a concave lens shape. In this case, when the lapping tool 44 is electrically gild by diamond whetstone grains, the quartz plate 13 can be easily lapped to the concave shape. Afterward, when the concave quartz plate 13 is lapped by the dual face lapping machine or one face machine, the concave quartz oscillator 13 is finished up in the concave shape as seen in Figure 43 (b).

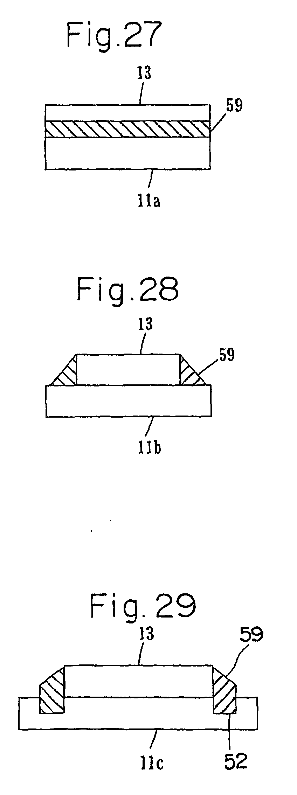

The lapping auxiliary tool 11a or 11b in a plane shape is made from Quartz, super steel, plastics, quartzite, glass or metal plate as shown in Figure 27, Figure 28 and Figure 29 in addition to those structures in Figure 11 and Figure 12. An adhesive layer 59 is made from pine resin and paraffin and so forth as shown in the hatched zone, the quartz plate 13 in the plane or convex shape is fixed and connected to the auxiliary tool. This plate 13 and tool 11a or 11b are lapped by the dual-face lapping machine (lapping table). After the one face lapping machine 17 is laps the auxiliary tool and another one 18 does the quartz plate 13, the Quartz plate is detached from the tool. This procedure enables the quartz plate 13 to be lapped accurately down to very thin shape regardless of thickness of the carrier 37 of the lapping table. When the material of the tool 11c in Figure 29 is quartz or super steel, the following merits are got compared to the tool 11b in Figure 28.
(1) The quartz plate 13 can be fixed to the auxiliary tool 11c by the side wall of the plate 13, since the adhesive layer 59 is thicker than that in Figure 28.
(2) Even if the thickness of the plate 13 becomes extremely thin, the plate 13 can be connected the tool 11c, since the thickness of the layer 59 can be thicker.

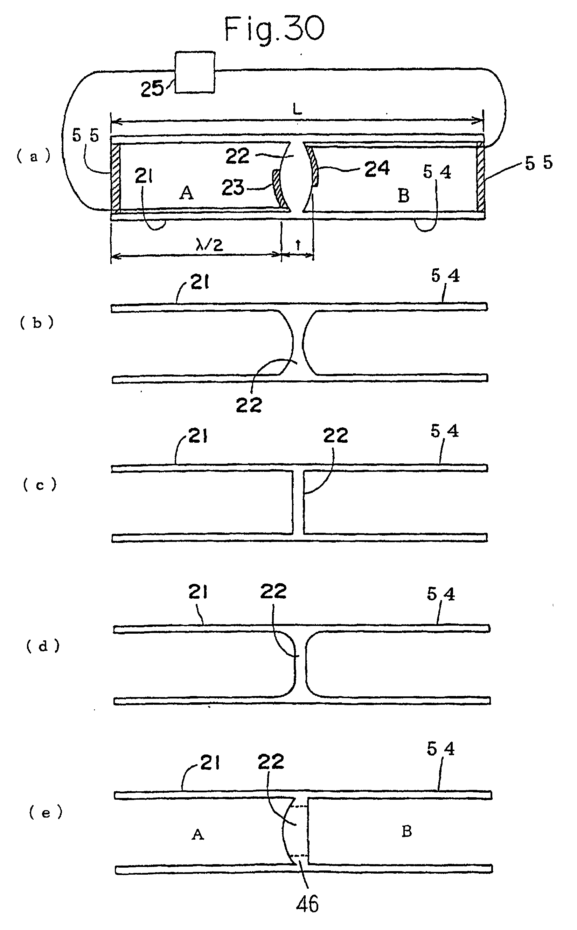

(From Figure 30 to Figure 41, the examples of sound to electric converter are given in the last part of this section.)

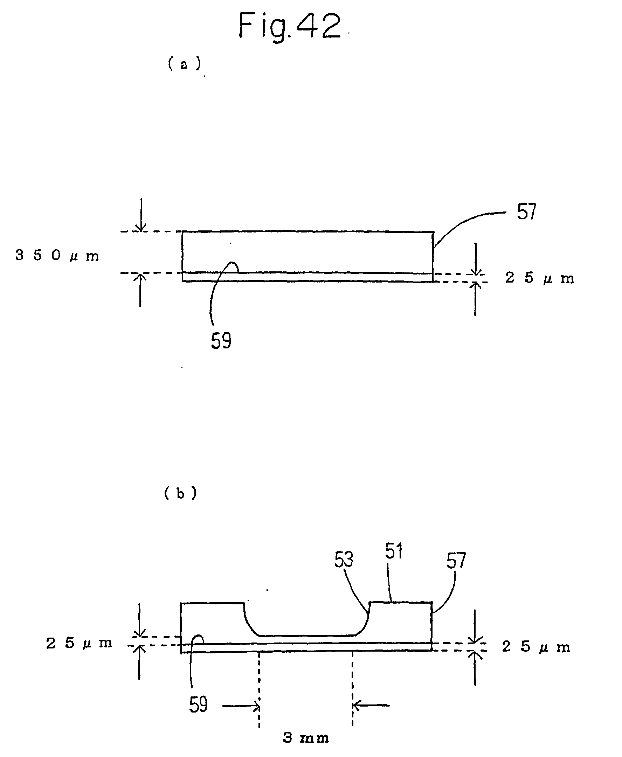

Figure 42 (a) shows a piezoelectric plate 57 for an angular velocity sensor, this is made by pasting two piezoelectric plates 57 of lithium niobate or potassium niobium and so on to an adhesive layer 59 of isolator. One side of the piezoelectric layer 57 is thick as 350 µm, and another side of the layer 57 is thin as 25 µm.

Figure 42 (b) shows a piezoelectric plate of static electric capacity type, which is developed by the manufacturing method in Figure 1. In this case the central thick part of the piezoelectric plate 57 is machined to be in a circular concave lens shape (inverted mesa) of 3 mm diameter, the thickness of the lens is 25 µm, and the adhesive layer is also 25 µm.

Figure 43 (a) shows the shape of quartz plate 13, which is made by the following process.
(1) The plate 13 is masked by the resist pasting, the membrane is made from metal film or other materials.
(2) When the plate 13 is lapped by the chemical wet etching or by RIE process of fluorine gases, the concave inverted mesa type is made at the diameter of 1.5 mm for example.

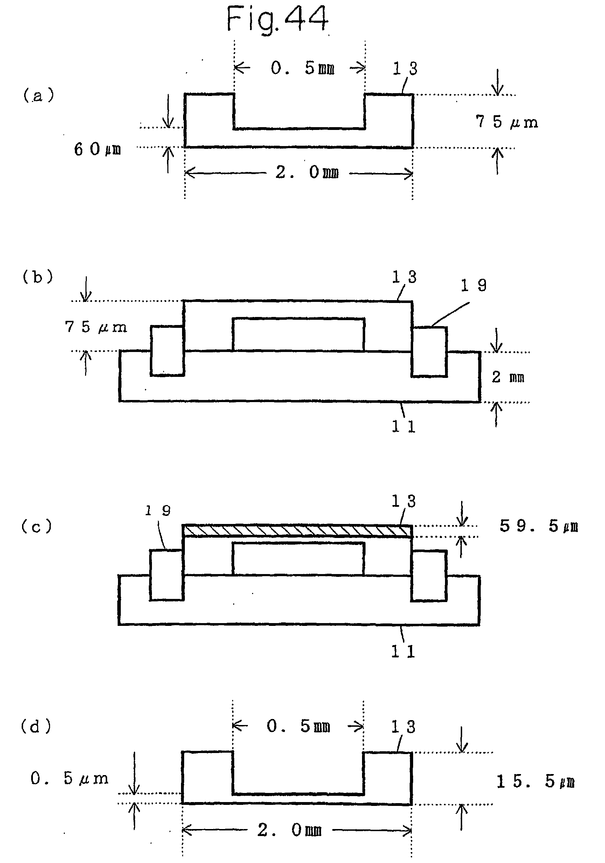

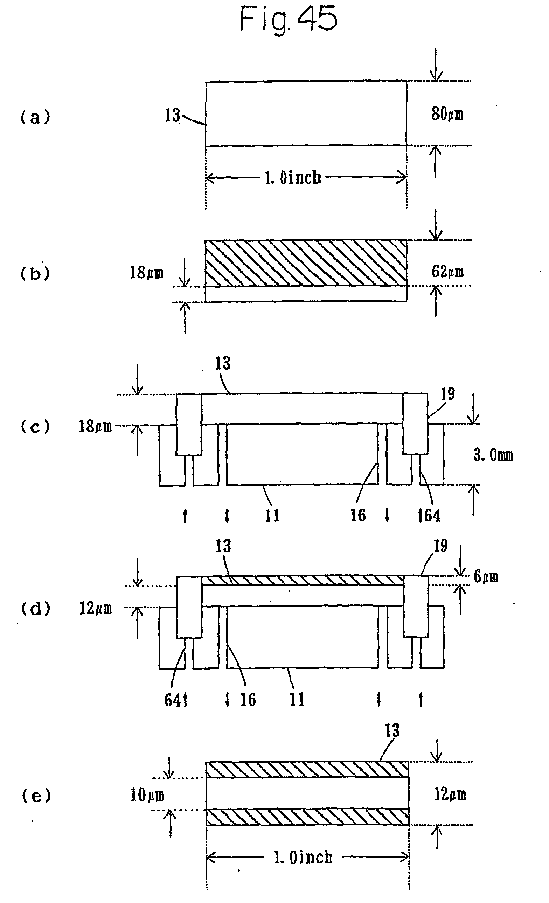

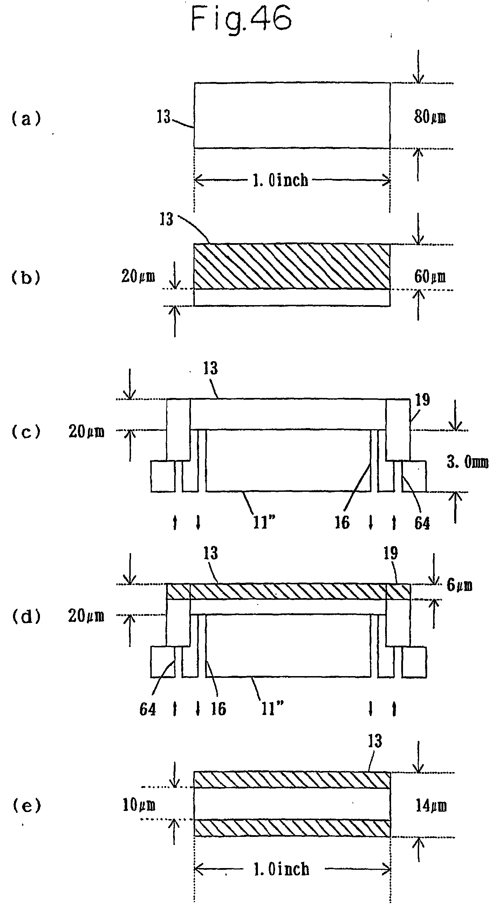

The following merits are listed for the lapping method as shown in Figure 44, Figure 45 and Figure 46.
1. The dual face lapping machine can make quartz oscillators in extremely thin plane or concave shape.
2. When the dual face lapping machine is used to make oscillators, the machining accuracy of the plane and concave part is unchanged, since the rear surface can only be lapped without machining the plane or concave surface.
3. When the dual face lapping machine is used to make oscillators from the rough lapping to the fine polishing, the machining accuracy of the plane and concave part is unchanged, since the one side lapping can be done with the first lapping auxiliary tool 11.
4. The one side lapping method with the first lapping auxiliary tool 11 can maintain the parallel accuracy and plane accuracy for the dual face lapping machine.
5. The first lapping auxiliary tool 11 can accomplish the merit for the RIE or chemical etching, one side lapping machine and for the dual face lapping machine.
6. The first lapping auxiliary tool 11 can cancel the disadvantage of one side lapping machine.

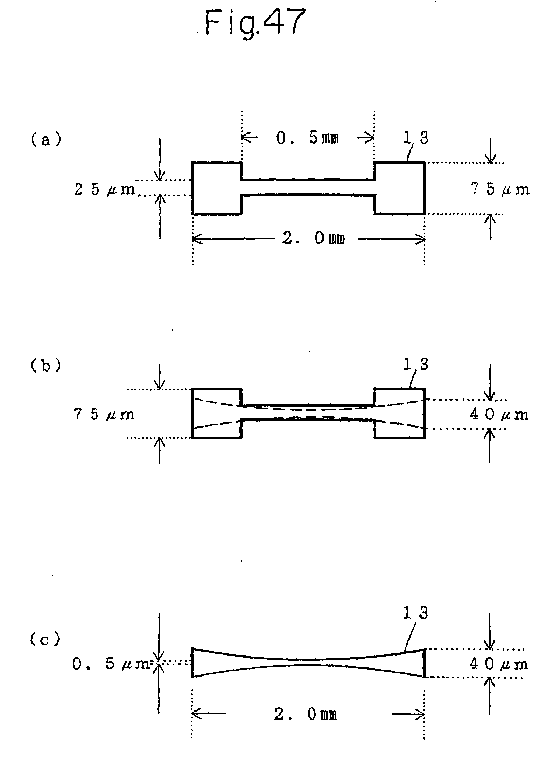

Figure 47 shows the shape of the quartz oscillator which electric property is enhanced by motioning the dual face lapping machine like a planet on the quartz plate 13, which both sides are made to be concave by RIE, plasma or other wet etching process, and by eliminating the reaction changed layer (fluorine combination or oxide layer) due to the wet chemical etching and so forth, without using the first auxiliary lapping tool 11 shown in Figure 13.

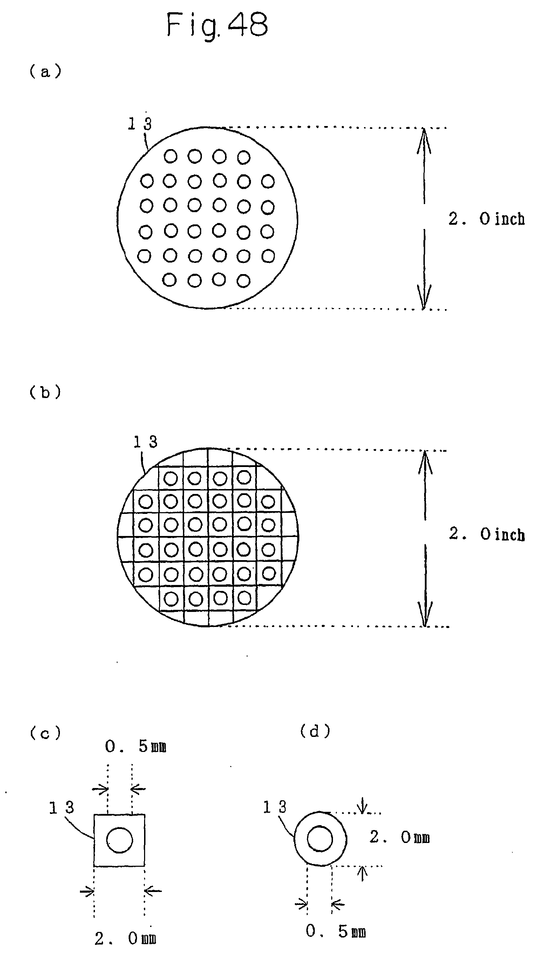

Figure 48 shows the ground plans of masking on the quartz plate 13 of 2 inch wafer, when the quartz plate 13 is actually made, of the etched quartz plate 13 in hundreds and thousands of planer, one-side concave or both-side concave shape by the chemical etching process, and of a rectangular or circular blank after the Quartz plate 13 is cut. By the way the rectangular shape is usually employed, though the circular shape is seen in Figure 48 (a) and (b).

Although only one blank is made in Figure 44, 45, and 46, many blanks are actually etched at the same time as shown in Figure 48 where the quartz plate 13 of 2 inch wafer is etched by the wet chemical process and so forth after it is masked by the resist powder.

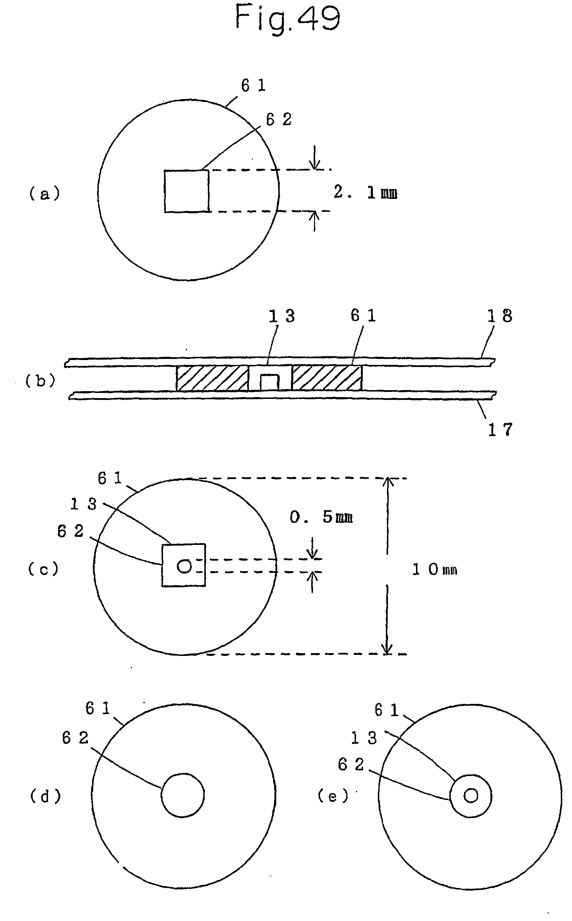

The quartz plate 13 which has many holes of single-side concave, double side concave or planer shape after substantial etching processes is lapped by the lapping auxiliary tool 11, the tool 11' or the third auxiliary lapping tool 61 in Figure 49. Otherwise, the dual face lapping can be directly done by the planet motion of the carrier 37 in Figure 20, or the plate can be machined by the single side lapping machine. By these processes the precise costless plate 13 can be mass-produced in a short time by individually cutting the quartz plate 13 after the wet chemical etching again to adjust the resonance frequency.

When the quartz plate 13 of 2 inch wafer in Figure 48 (a), (b), (c) and (d) is lapped to be concave in one by one, hundreds, thousands pieces, the quartz plate 13 can also be directly lapped dual facedly by the planet motion with the carrier 37 in Figure 20, after the plate 13 is inserted into the space 13 of the third auxiliary machining tool 61 which is made from plastic, super steel, steel or other metal and material.

Although Figure 49 shows one manufacturing process of lapping in addition to the machining of quartz plate 13, the lapping and machining processes of one by one, hundreds, thousands concaves are exactly identical to those of the plate 13 in Figure 49.

The manufacturing conditions of the quartz plate 13 in Figure 49 are that the rear surface of the concave shape is lapped by the lapping plate 18 pasted by the pad or suede 15 and that the concave surface is lapped by the lapping plate 17 of steel or metal plate as tin plate. When the lapping is done by the lapping agent 65 of tiny diamond, GC or cerium oxide and so forth, the quartz plate 13 is put into the space 62 of the third auxiliary tool 61, and the plate 13 combines the third tool 61. If the combined plate 13 and the tool 61 move always like a planet with the carrier 37 in Figure 20, the quartz plate 13 can be effectively manufactured up to the ultimate accuracy, since the third tool 61 which is made from super steel etc and located around the plate 13 improves the parallelism and surface accuracy of the lower lapping plate 17 of tin and so forth.

When the cerium oxide is used to lap due to the good fitting of the quartz plate 13 as a lapping agent 65 by using the lower lapping plate 17 of metal as steel and tin and the upper lapping plate 18 pasted by the pad or suede 15, over 90 percent of the lapped thickness is machined by the upper lapping plate 18. Therefore the oscillating plate of the Quartz plate 13 is only lapped to be very thin step, since the rear flat surface of the concave plate 13 can solely be machined as shown in Figure 49 (b).

Furthermore even if the height of the third tool 61 is same as that of the concave quartz platel3, the plate 13 inside the tool 61 can be lapped approximately into 15 µm, when the lapping plate 18 of urethane or fabrics is used, since the third tool 61 is made from super steel. For instance when the plate 13 is 80 µm thick, the quartz plate 18 can be lapped to 80µm-15µm=65µm, even if the height of the third tool 61 is same as that of the plate 13.

There are some cases where the rectangular pate quartz plate 13 inside the rectangular space 62 with the third tool 62 and the direct carrier 37 in Figure 49 (c) is lapped more effectively than that in the circular space 62 in Figure 49 (e).

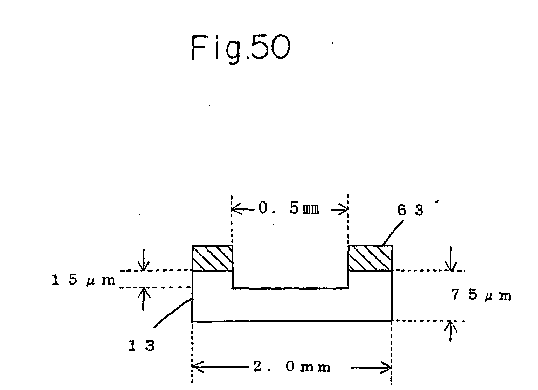

Figure 50 shows the lapped states of quartz plate 13 which is 15 µm deep concave, when the plate 13 is etched by RIE from the upper side of the plate 13 after masking the plate 13 by a mask plate 63 which is made from the ultrasonically machined quartz with 5 mm holes, Tungsten or other materials.

It is the reason why the masking plate 63 is used instead of the masking metal membrane that the membrane on the quartz plate 13 is utterly consumed to zero during the lapping process to the concave 15 µm which shape, since the thickness of the optically made membrane is only 1 µm. Then it is impossible for the quartz plate 13 to be shaped more deeply down to 15 µm by RIE process without employing the masking plate 63 with 0.5 mm holes for example. The material of the masking plate 63 for RIE is quartz or similar one as quartzite, since the surface of the quartz plate 13 is dissolved by fluorine gases for RIE, deposited by other material in the plasma state and becomes rough. Then the precise making of the quartz plate 13 becomes impossible, and quartz and similar quartzite is utilized for the masking plate 63 on the quartz plate 13. If Pyrex is used for the masking membrane 63 as a poor case, various impurities as aluminum in Pyrex is dissolved by fluorine gas, the combined alumina deposits on the surface of quartz plate 13, and we can use Pyrex etc.

Instead of the above methods, it is possible for the masking easily to paste the resist on the surface of the quartz plate 13 by Dry Film (trademark of Dupon MRC Dry Film Inc.). Another method of the masking can be to paint the resist on the surface of the quartz plate 13.

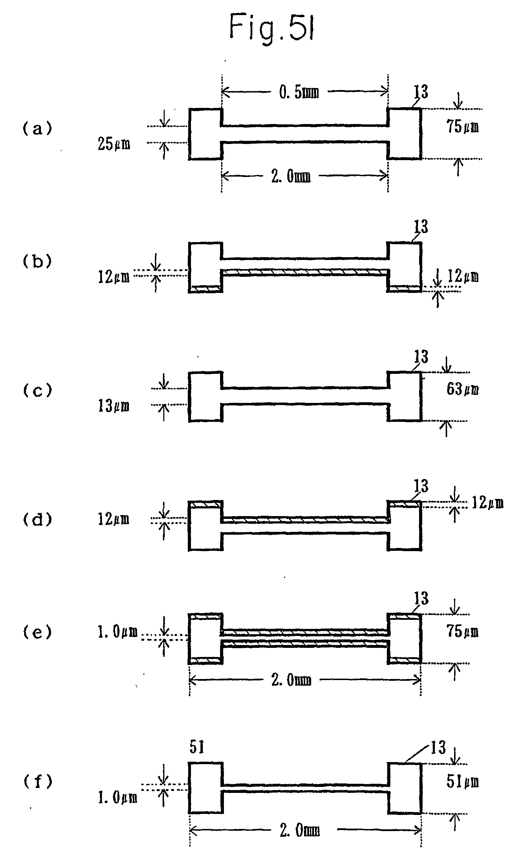

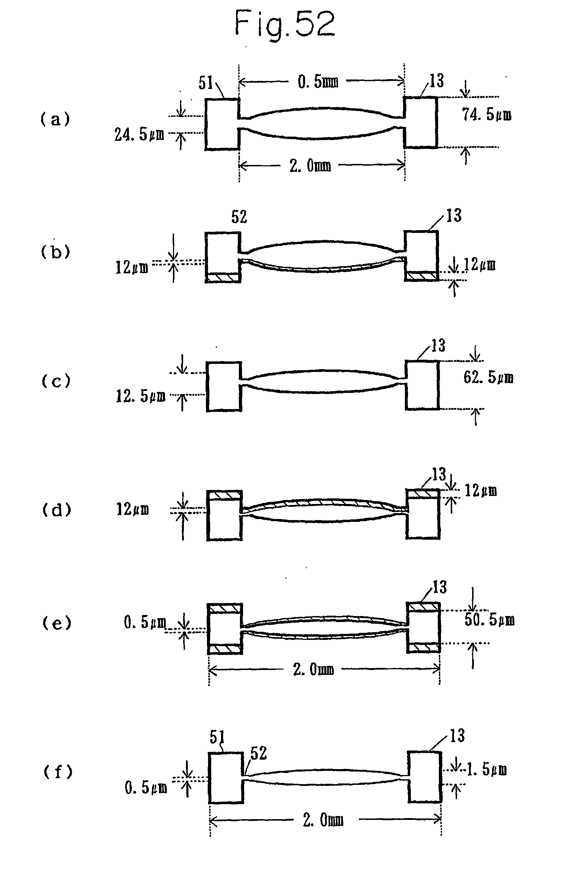

Figure 51 and Figure 52 show a mechanical lapping method, after the quartz plate 13 is etched in the double-sided concave or convex shape by means of RIE, the plasma etching or other chemical wet etching processes. It is for the etching changed layer of the chemical wet etching process in the concave shape to be eliminated by the dual face lapping machine or the one face lapping machine as the secondary lapping method, and to make the accurate parallel surface without the undulation. The quartz plate can be lapped to be ultimately thin by the mechanical lapping method, by smoothing the rough surface due to the etching.

In these Figures the hatched area is eliminated by using the mechanical lapping or the chemical etching process.

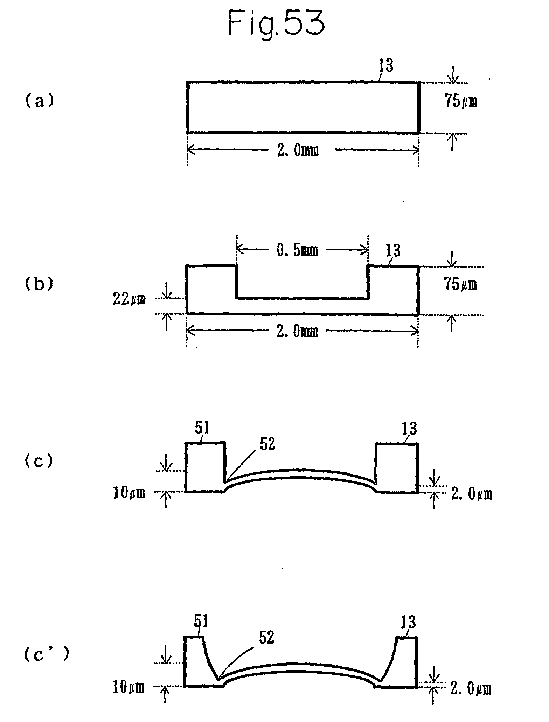

Figure 52 and Figure 53 show the second manufacturing method of the quartz plate 13 which central part of 0.5 mm diameter was previously lapped by RIE or other wet etching processes, while the first method is the finishing mechanical lapping process in Figure 1 (a). Since the second method requires small gripping area to lap the quartz, it becomes possible for the plate to be machined to be convex in the single or double sided shape in a short time, and also to be made to combine the holder 51 to the convex or concave lens part by the smooth line 53 as seen in the Figure.

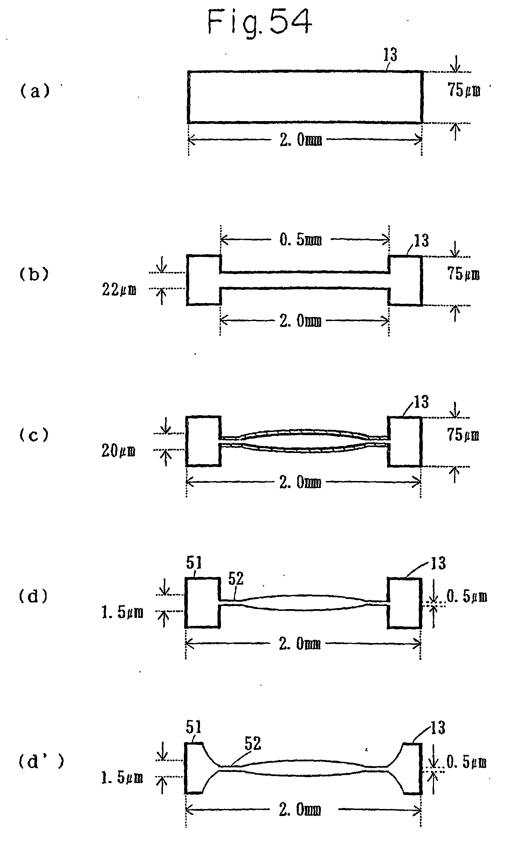

After the quartz plate is machined to the bi-convex shape both by the machining and lapping processes in Figure 54 c, and the both faces are similarly lapped as 9. 25 µm by RIE etching, ultra thin quartz oscillators are easily manufactured very accurately as seen in Figure 54 (d) or Figure 54 (d').

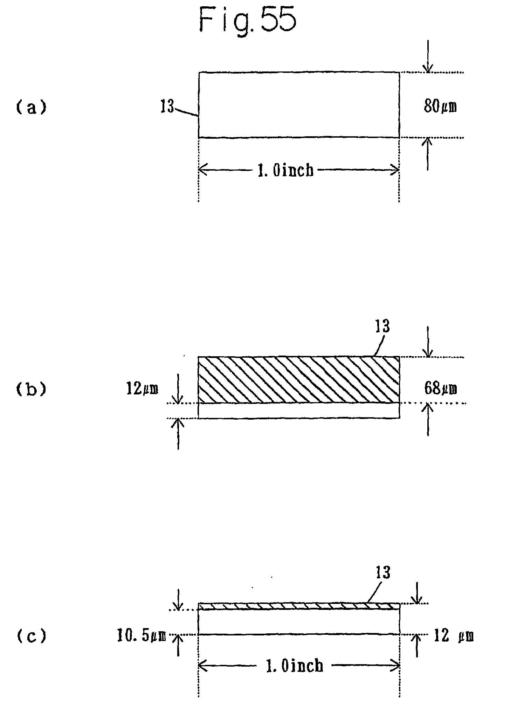

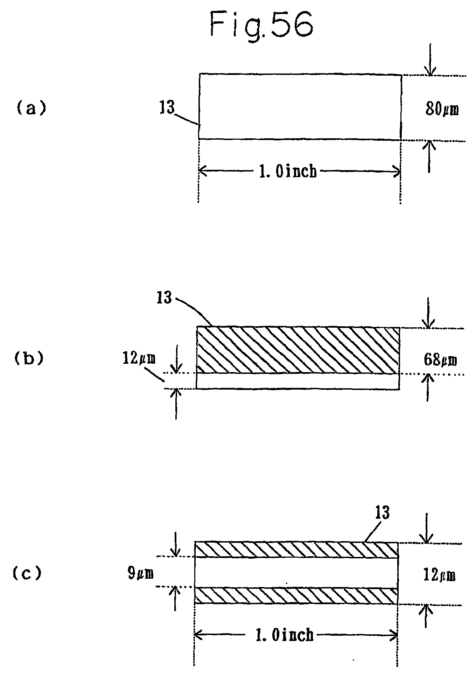

Figure 55 (a) and Figure 56 (a) shows one inch rectangular quartz plate 13, which is lapped to be 80 µm thick in the mirror surfaces by the dual face lapping machine.

Figure 55 (b) and Figure 56 (b) shows 12 µm thick quartz plate 13 which one side is lapped 68 µm by RIE process. Figure 55 (c) shows the 10.5 µm thick plate 13 which rough layer (non crystalline state due to RIE) as 1. 5 µm is lapped by the wet etching process. Figure 56 (c) shows 9 µm thick quartz plate 13 which is lapped as 1.5 µm from the both sides of 12 µm plate.

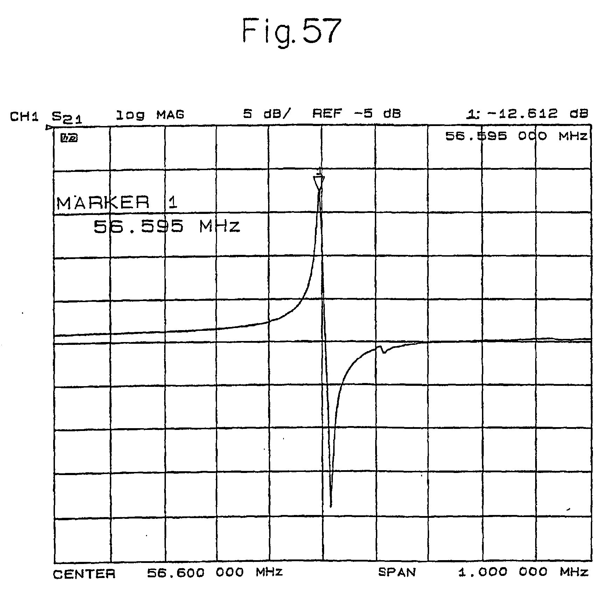

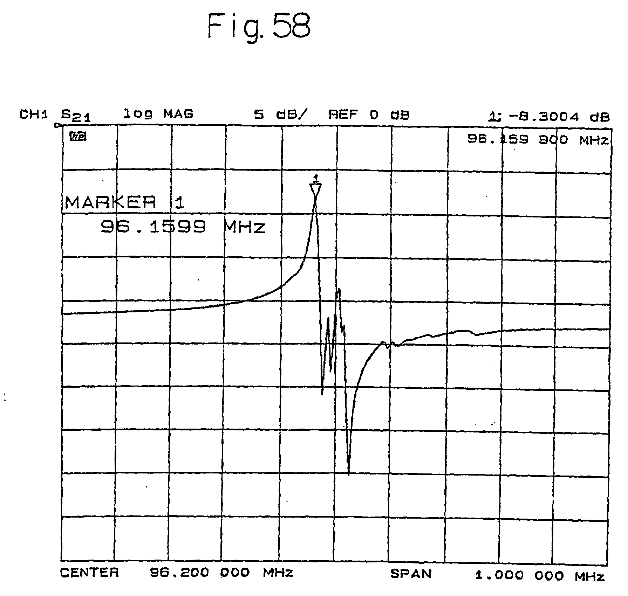

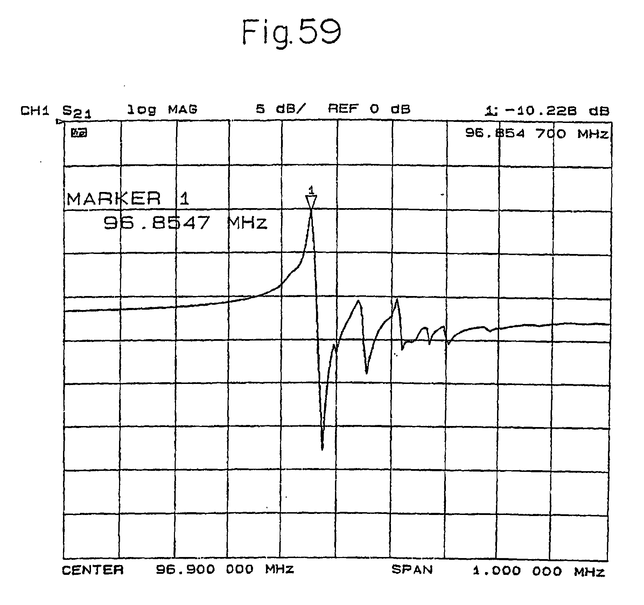

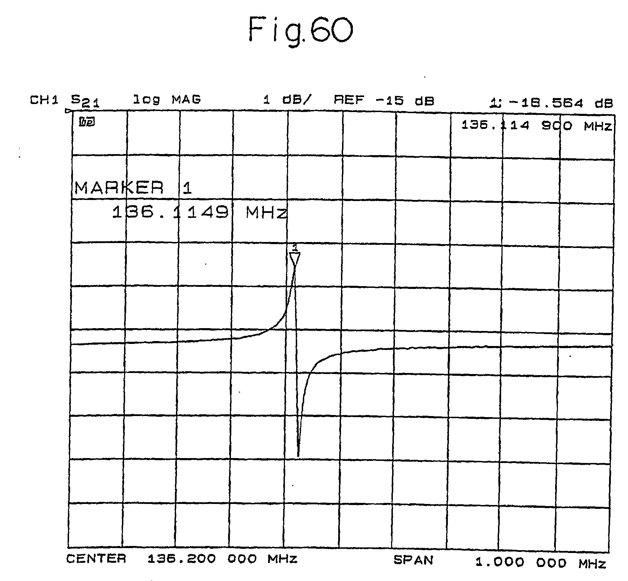

Figure 57 shows the electric frequency property (56.595 MHz), which is measured for the 29.5 µm thick plate similar to Figure 57. Figure 58 shows the property (96. 1599 MHz) of 17. 36 µm quartz plate. Figure 59 shows the frequency as 96. 8547 MHz of 17.2 µm plate. Figure 60 shows the frequency as 136.1149 MHz of 12.26 µm plate. These frequency-reactance characteristics are measured to be very excellent.

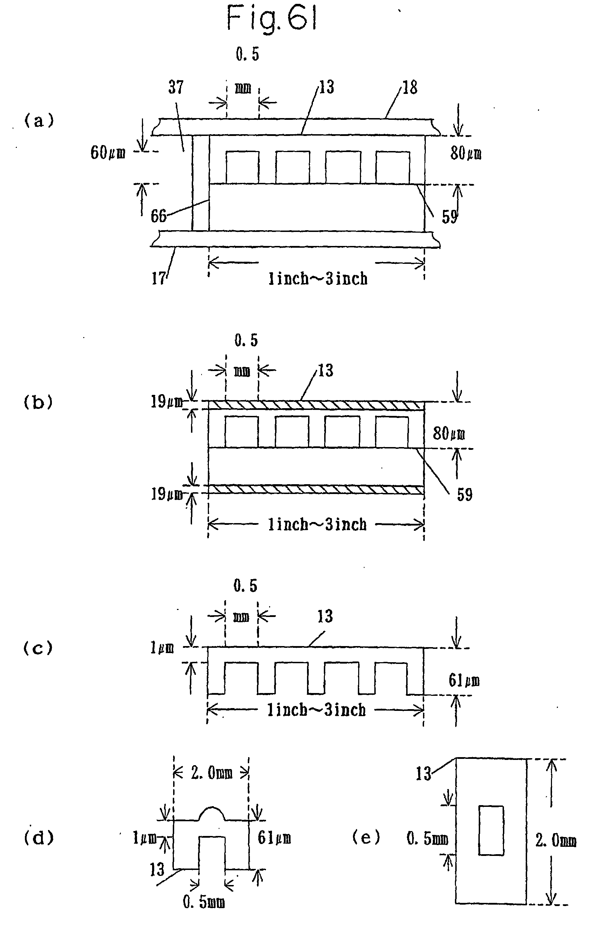

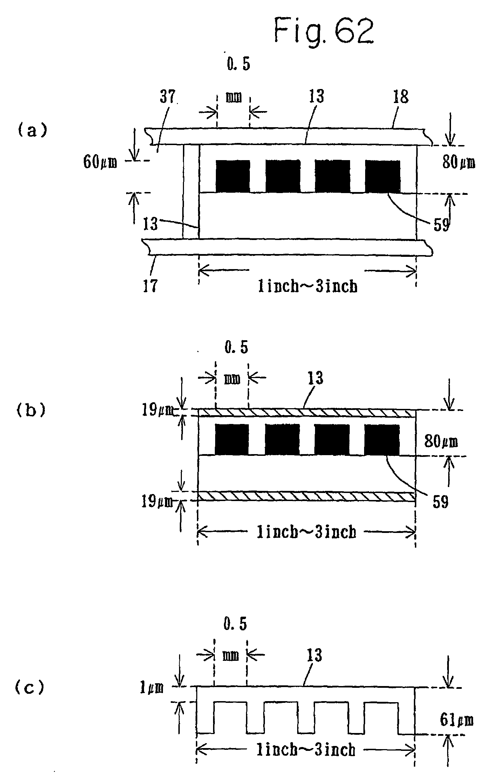

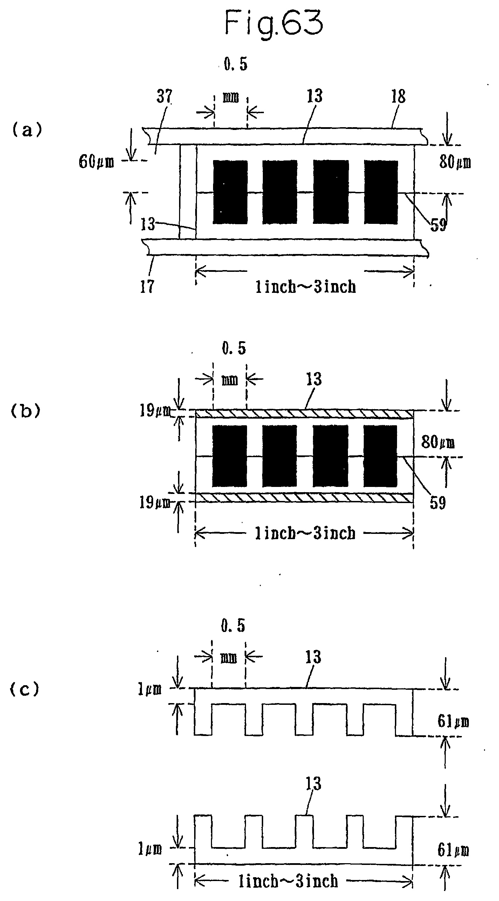

Figure 61 and Figure 62 shows the lapping process of the quartz plate 13, which has little distortion since the lapping plates 17 and 18 are made from same material as quartz as the plate 13. Figure 62 and Figure 63 have the hatched black region which is made from resin and used to reinforce the concave part of the plate 13.

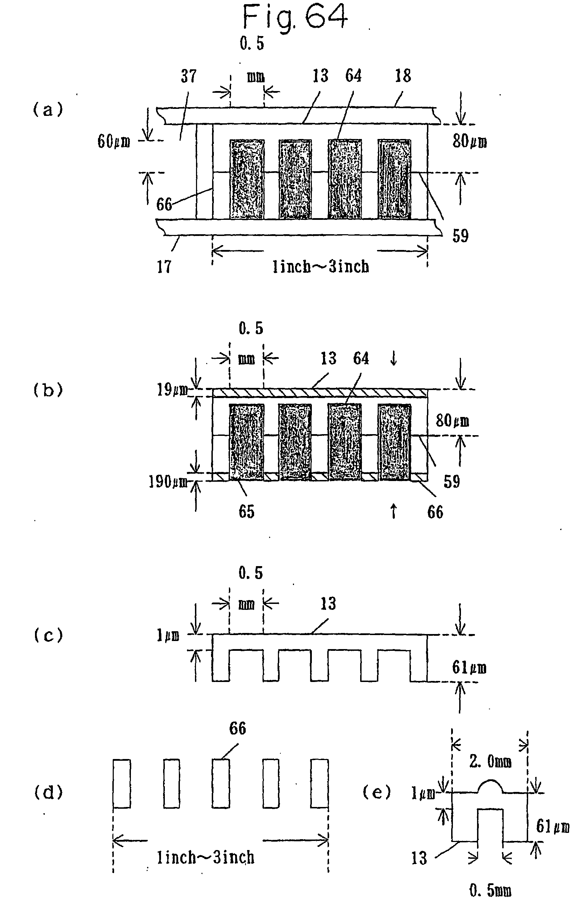

As shown in Figure 64, after the quartz plate 13 is pasted by the adhesive as pine resin on the forth lapping auxiliary tool 66 which is made from quartz, hard glass, metal or other material in a planar shape with holes 64, the rear surface of the plate 13 and one face of the tool 66 are lapped by the upper and lower lapping plate 17 and 18 of the dual face machine. The shadow region in Figure 64 is the balanced state of the lapping pressure to the concave internal force as seen in the arrow of Figure 64 (b), however there exists no concave shape. The stronger the lapping pressure is compared to the internal force, the better concave the quartz plate is seen Figure 64 (d).

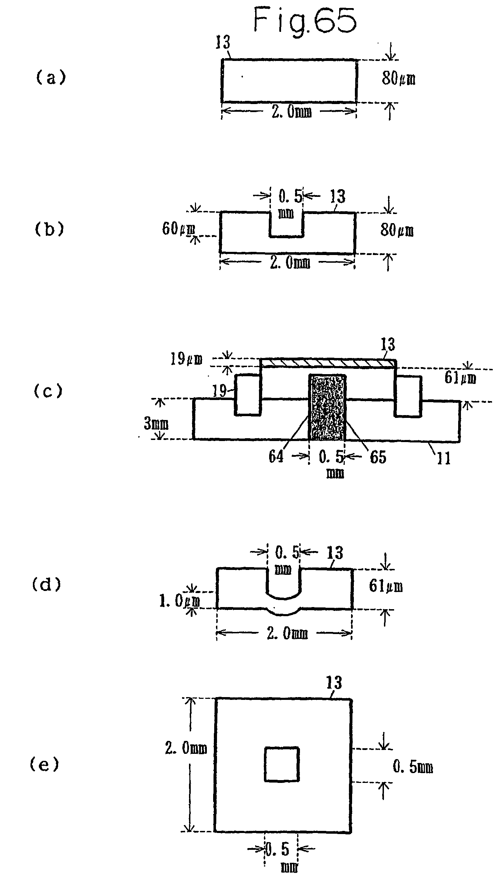

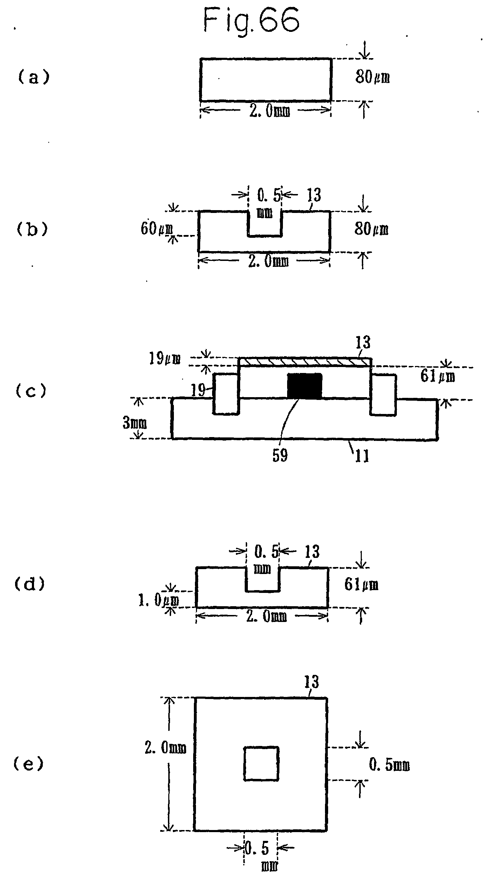

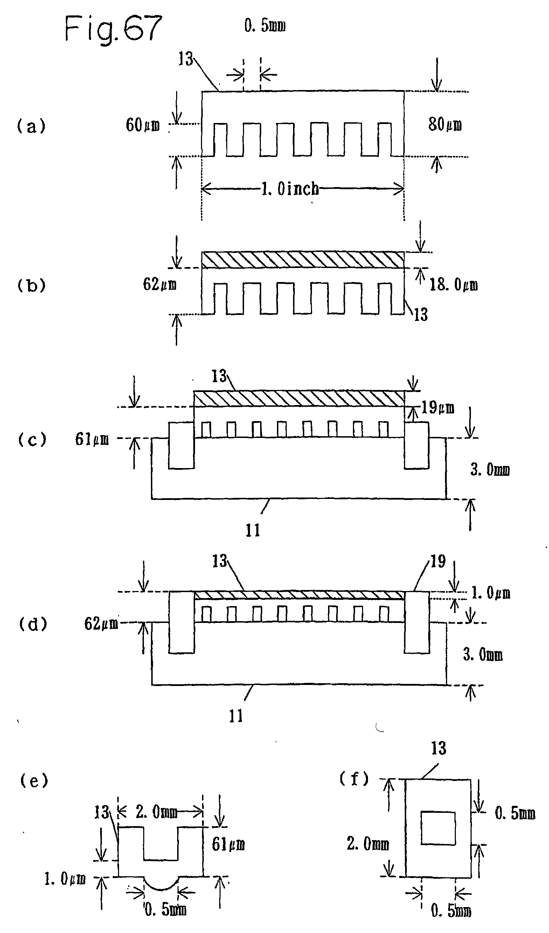

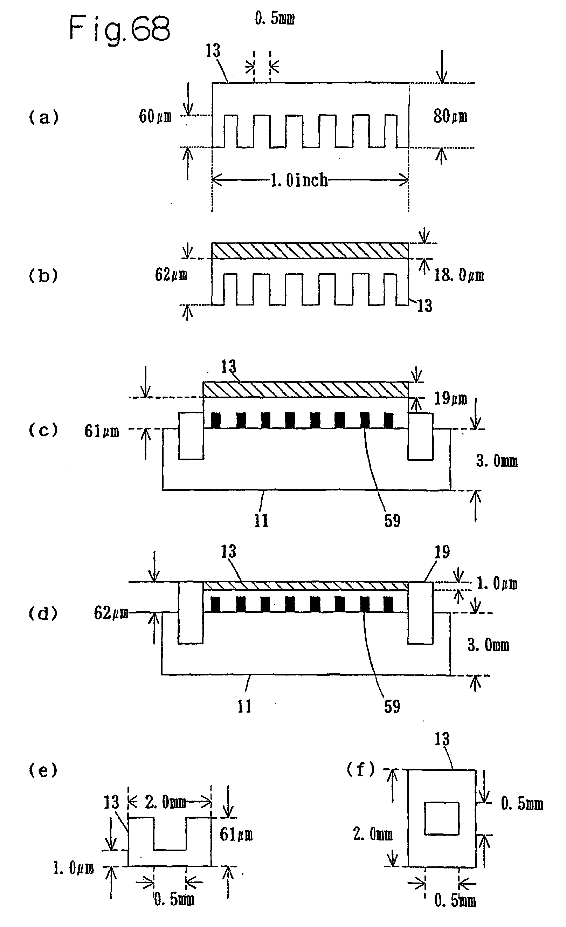

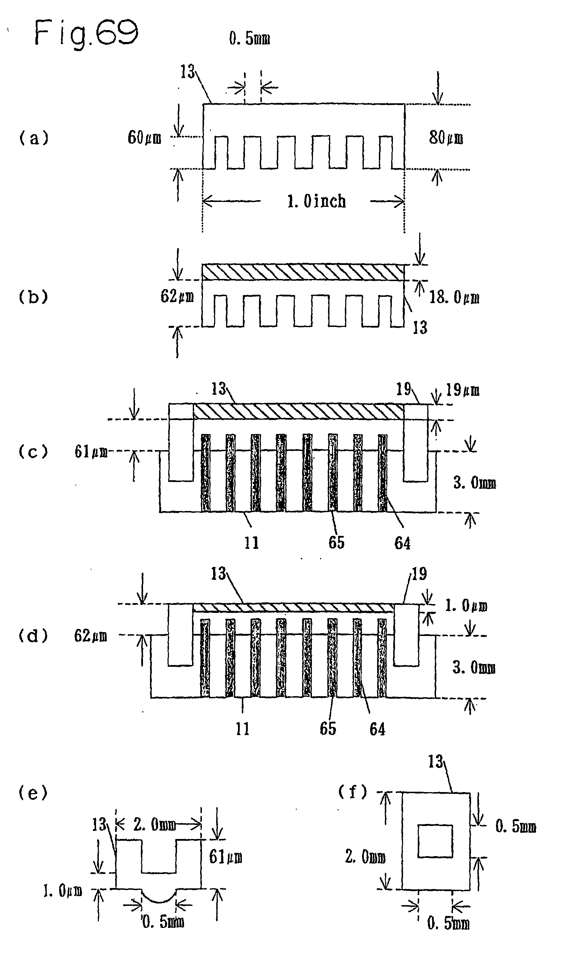

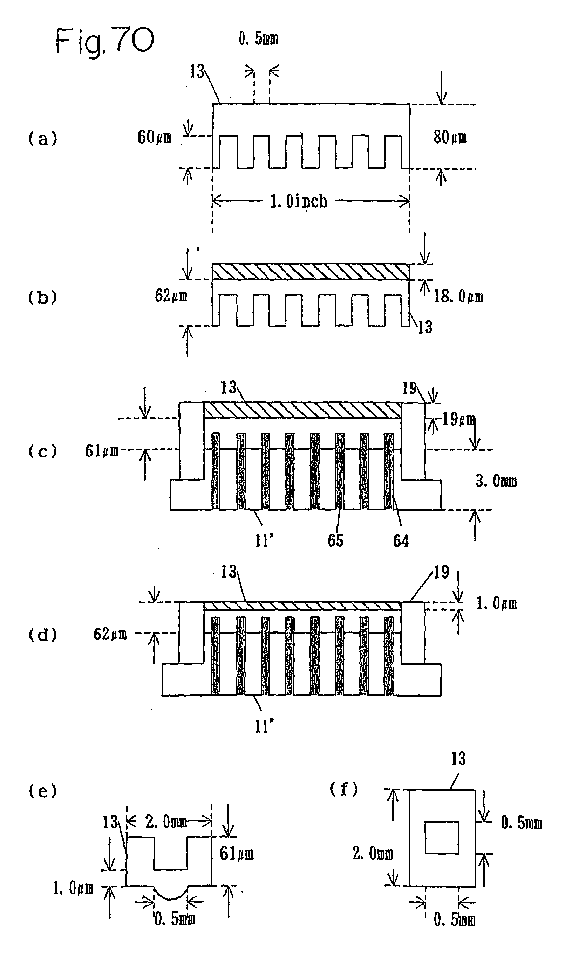

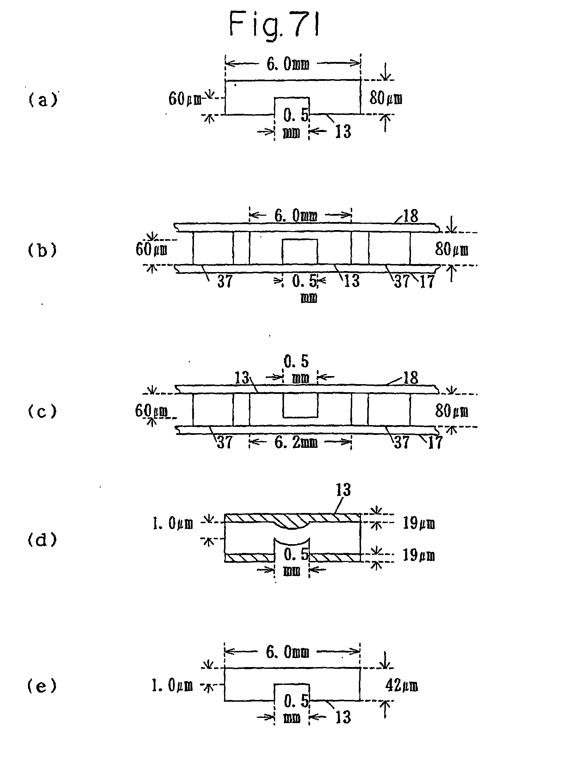

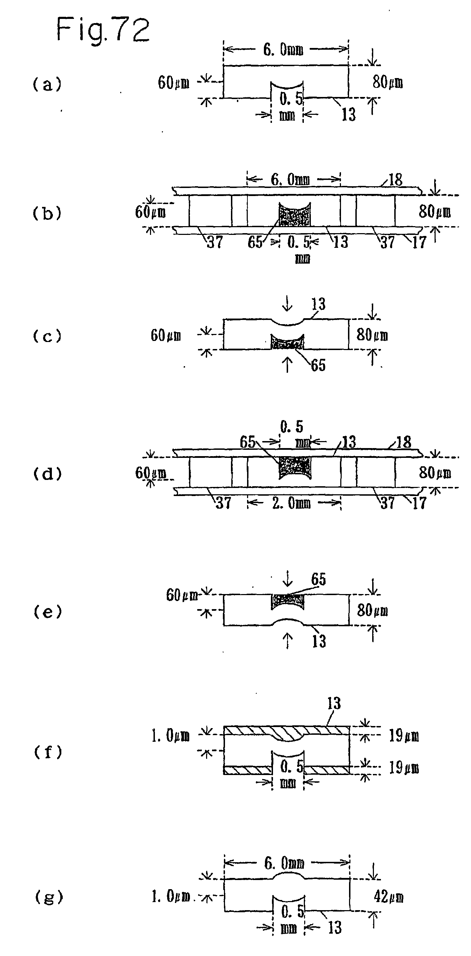

Figures 65, 66, 67, 68, 69 and 70 show the quartz plate 13, which is 80 µm thick and 60 µm deep concave as shown in Figure 61 and the diameter is 2 mm or 1 inch. Figure 71 and Figure 72 show the quartz plate 13, which is 80 µm thick and 6 mm diameter and the handling area is different.

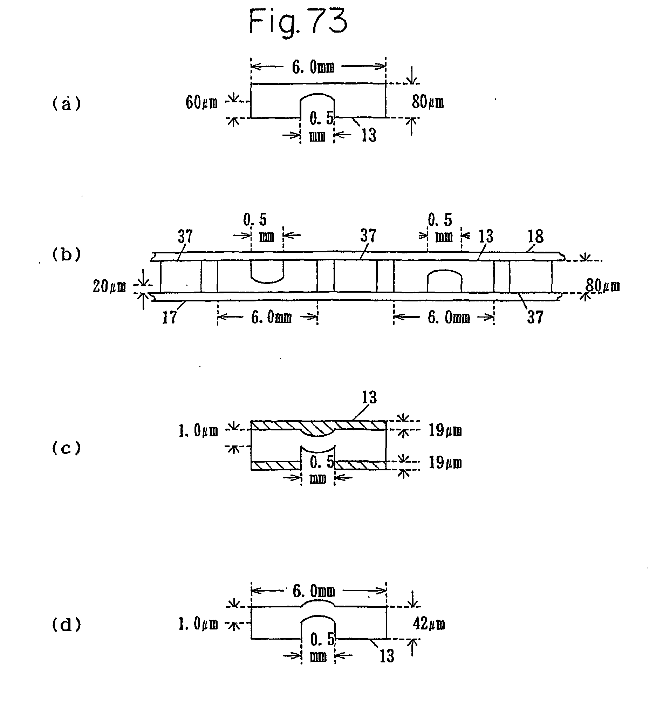

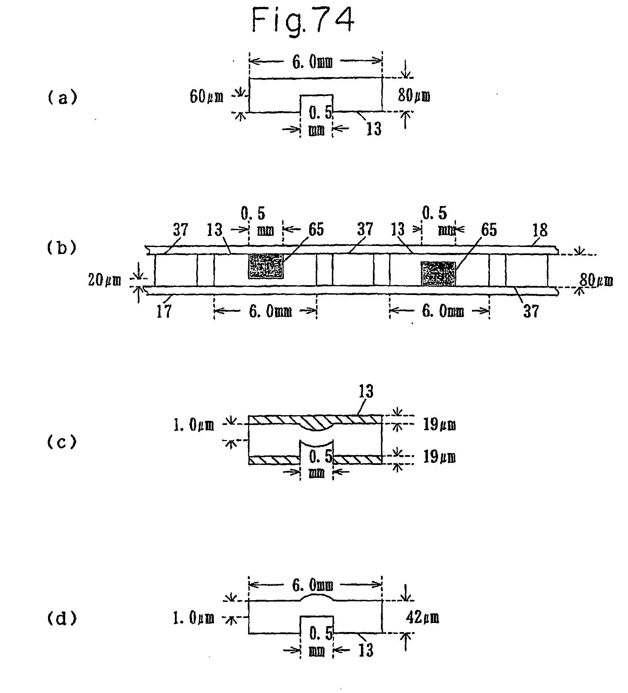

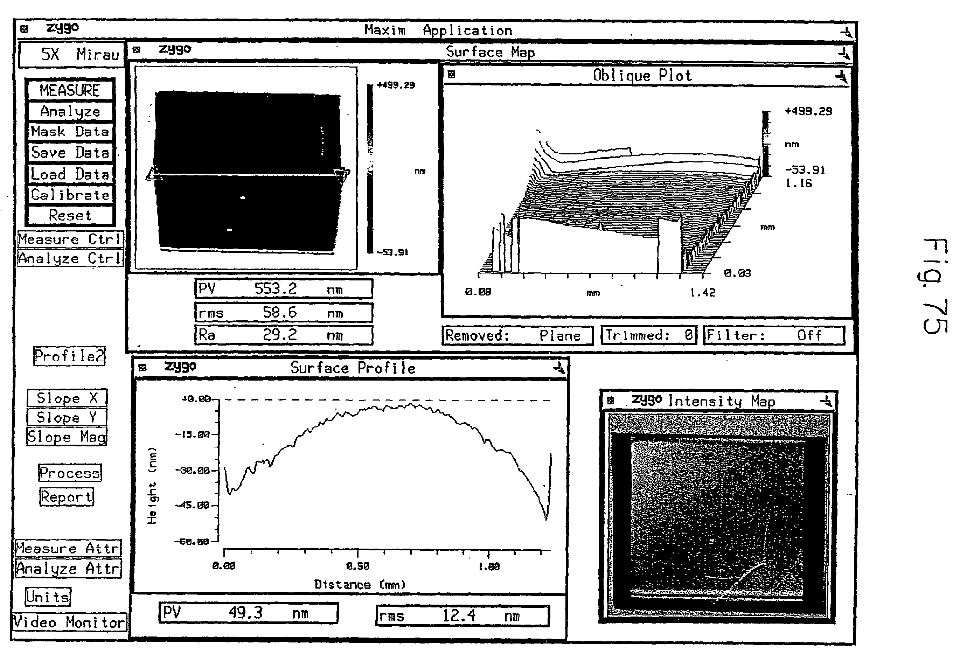

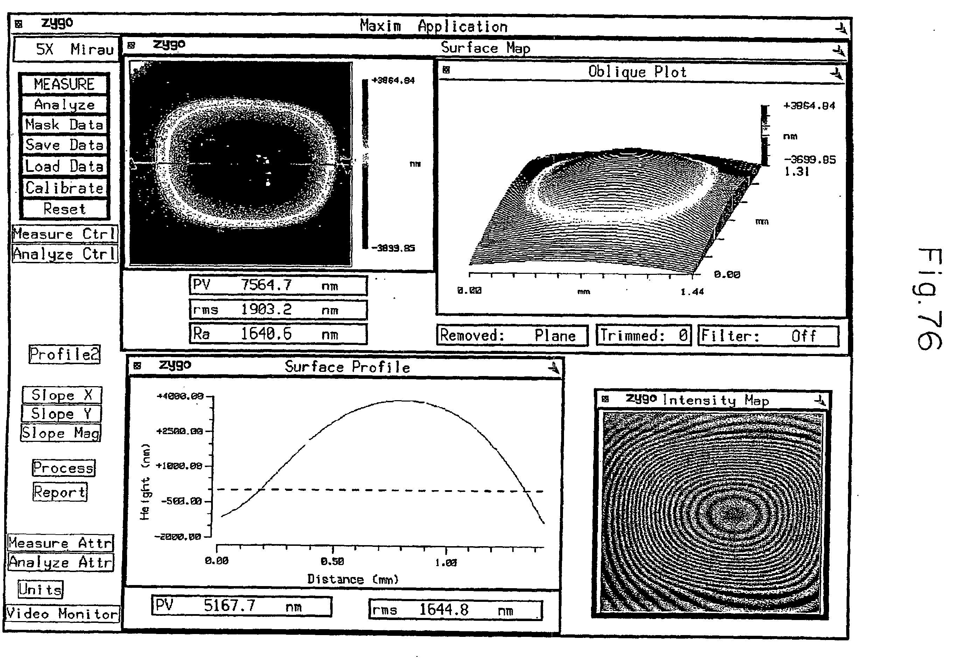

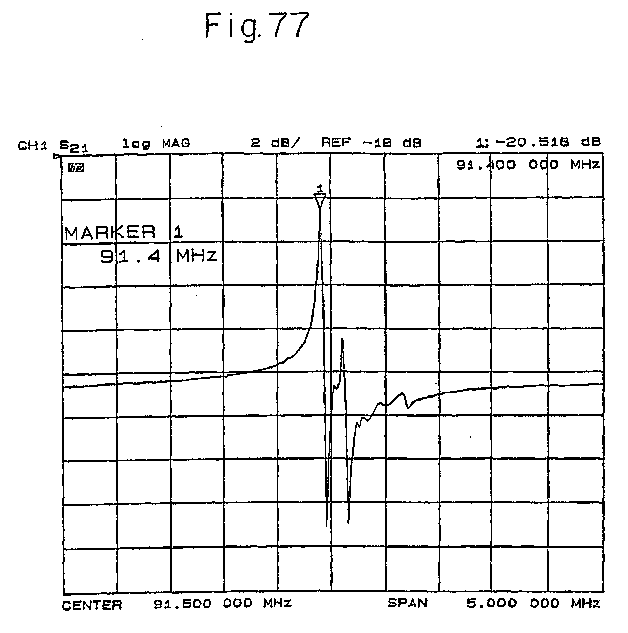

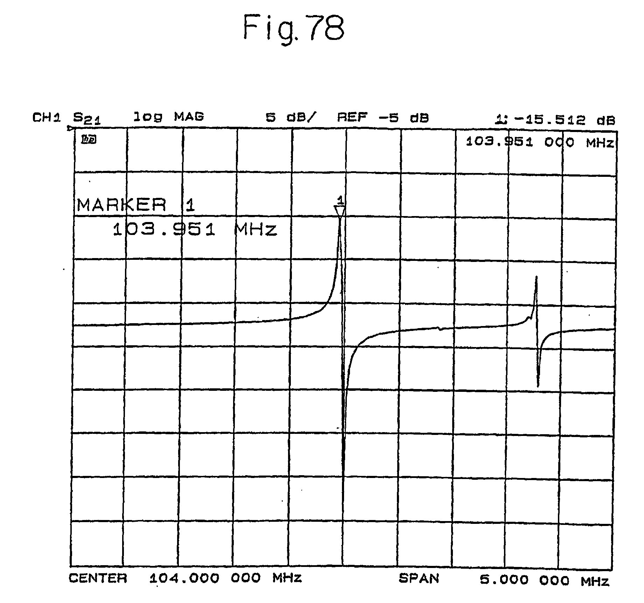

From Figure 71 to Figure 78, the quartz plate 13 is shown for 8 cases of the diameter 2, 3, 4, 5, 6 mm and 1 inch. Figure 75 is a measured diagram of the quartz plate 13, which one surface is machined to be in an inverted mesa type shape by the chemical wet etching process and another surface is in a plane shape. Figure 76 shows interference stripes of the resonating part, which is perpendicular to the rear concave surface of the quartz plate 13 in Figure 75, after the plate 13 is lapped b the dual face lapping machine in Figure 74 (d).

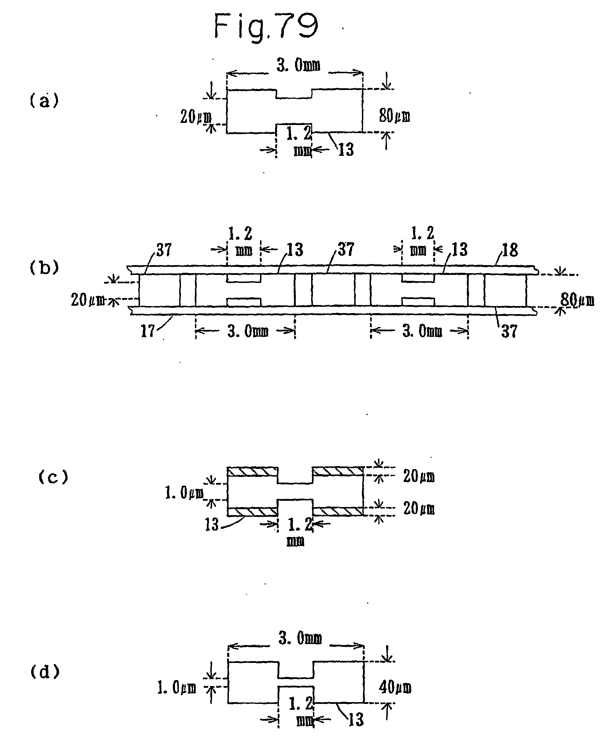

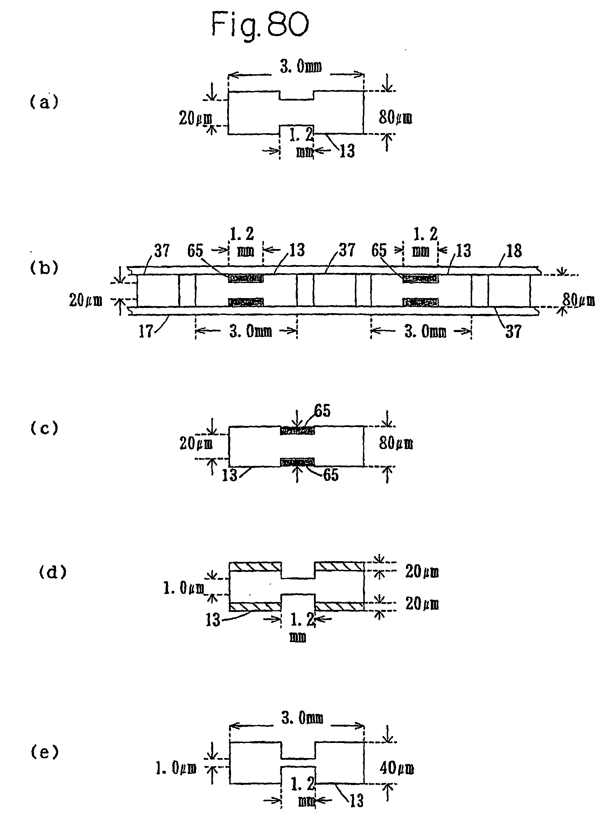

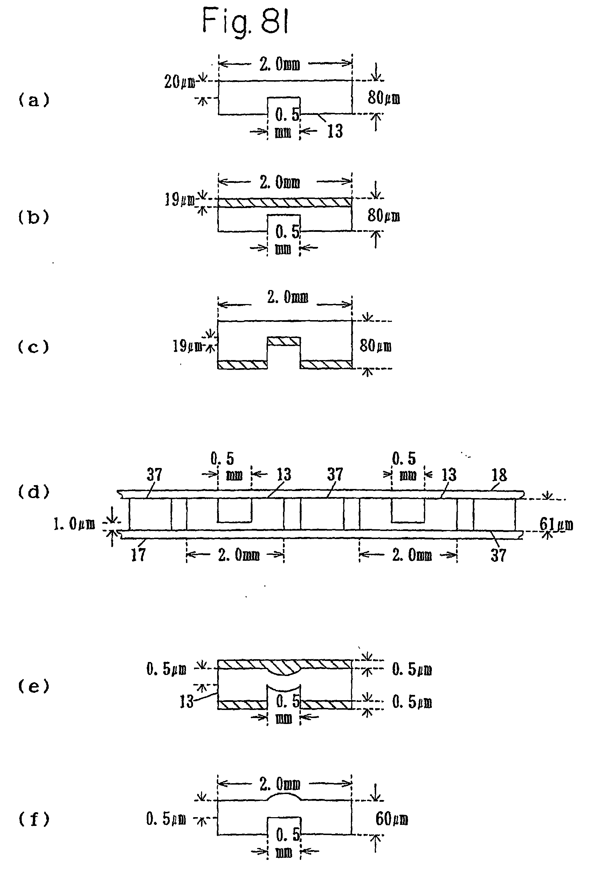

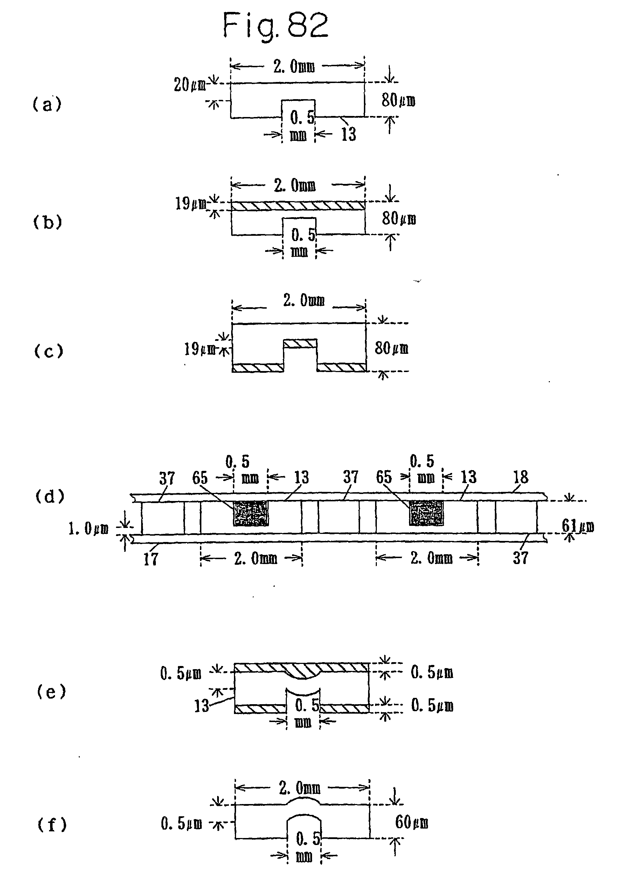

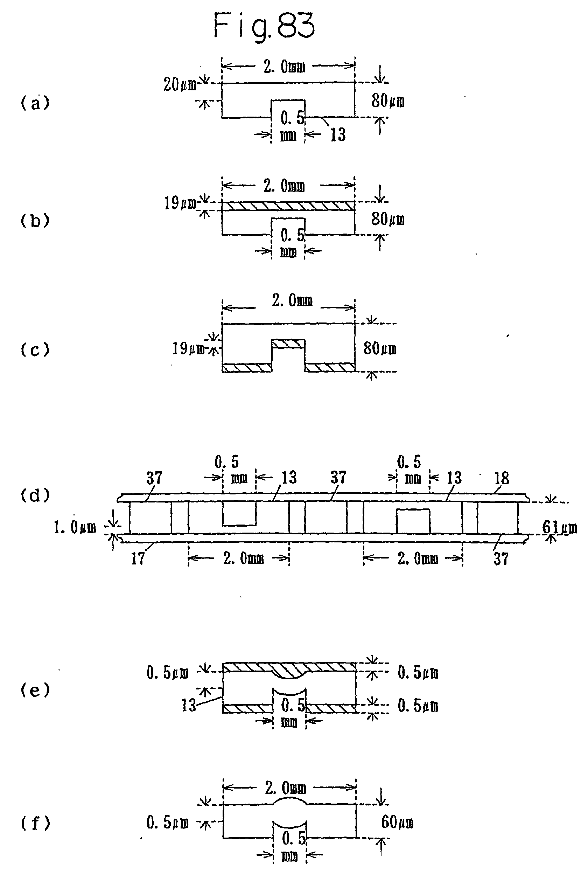

Figure 79 and Figure 80 show the lapping state of the quartz plate 13, which is double inverted mesa type after the plate is machined by the upper and lower lapping plate 17 and 18 of the dual face lapping machine in Figure 71. Figures 81, 82 and 83 show the lapping process of the quartz plate 13, which is double inverted mesa type after the rough surface (approximately from 0.1 µm to 0.5 µm thick) due to the etching is machined by the upper and lower lapping plate 17 and 18 of the dual face lapping machine in Figure 71. Figure 83 shows another lapping state of the quartz plate 13, which is machined by the upper and lower lapping plate 17 and 18 with the pad or suede 15.

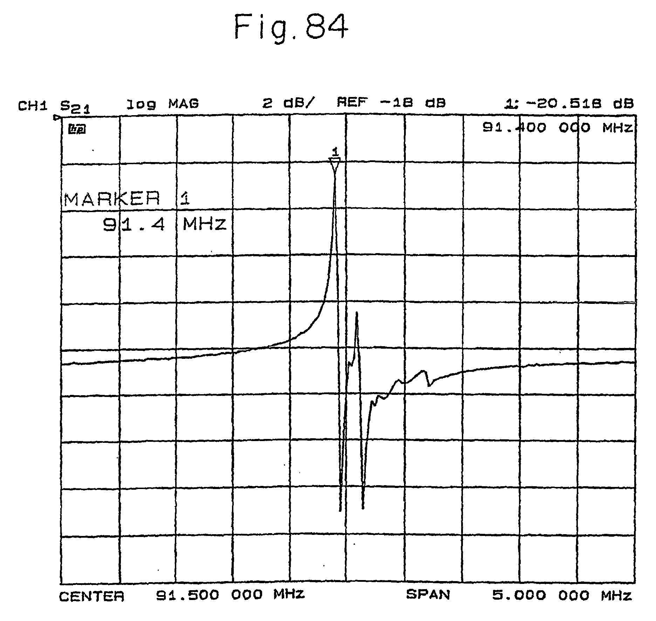

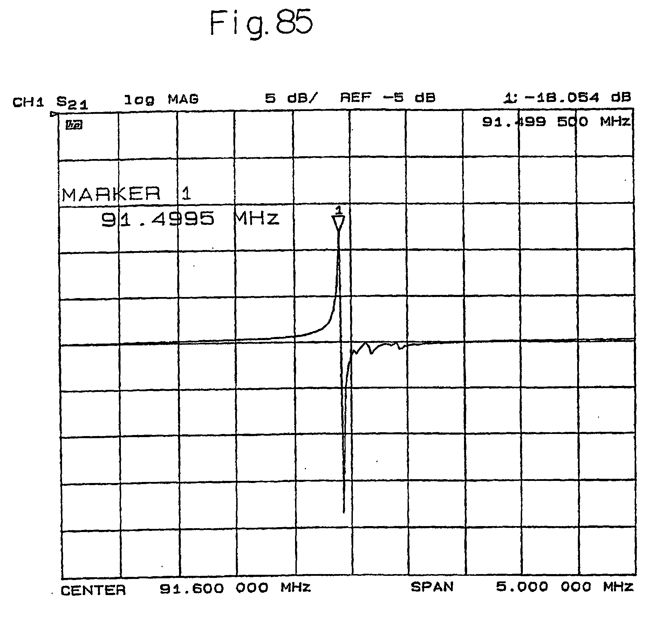

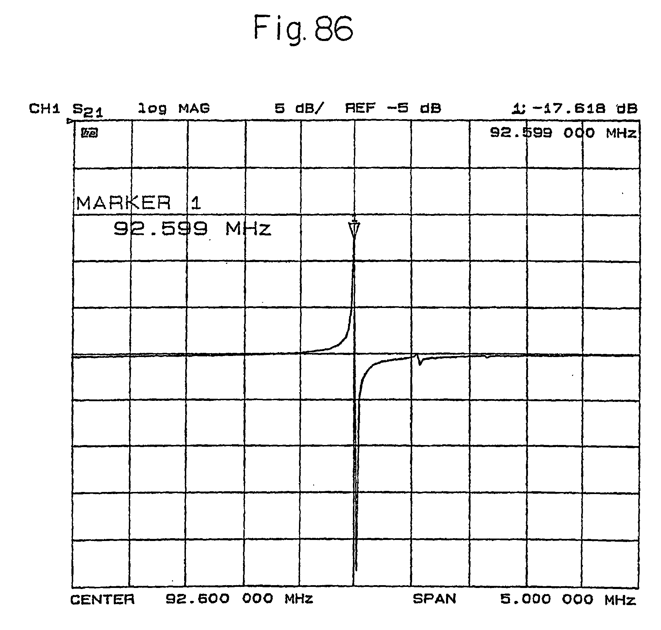

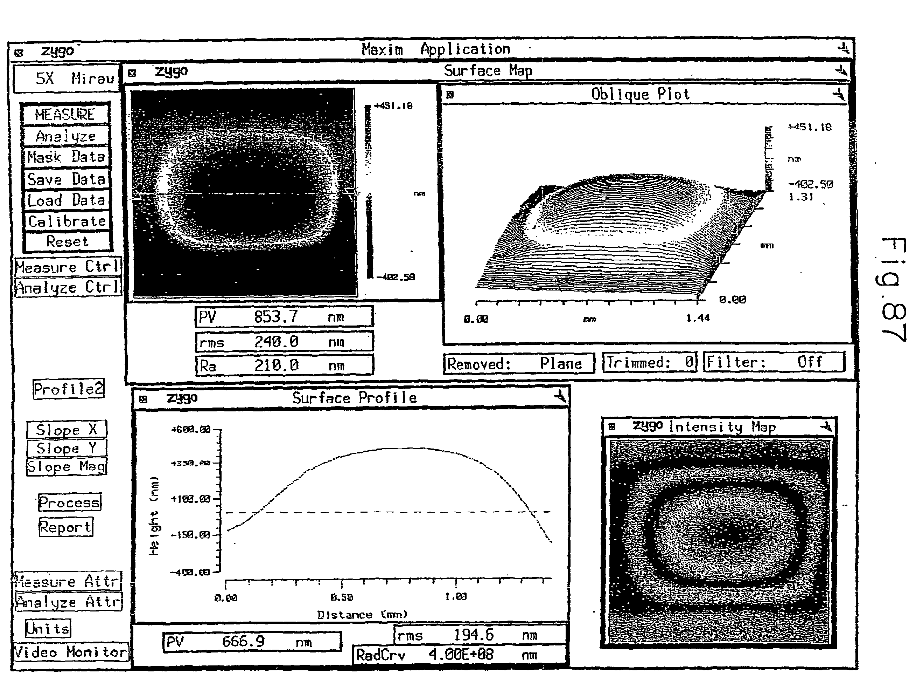

Figure 85 shows the reactance-frequency property of the quartz resonator 13, which is machined to be an inverted mesa shape by the lapping machine in Figure 84 and both rough surfaces (0.02 µm thick) are eliminated. The resonance frequency is 91.5 MHz, and the thickness of the plate in Figure 85 is 18.25 µm. Figure 86 shows the reactance-frequency property of the quartz resonator 13, which is machined to be an inverted mesa shape by the lapping machine in Figure 84 and both rough surfaces of 0.217 µm are eliminated and thickness of the plate in Figure 86 is 18.034 µm. Figure 87 shows the surface shape of the Quartz resonator 13, which resonating surface is enlarged and the convex height is 0.8 µm.

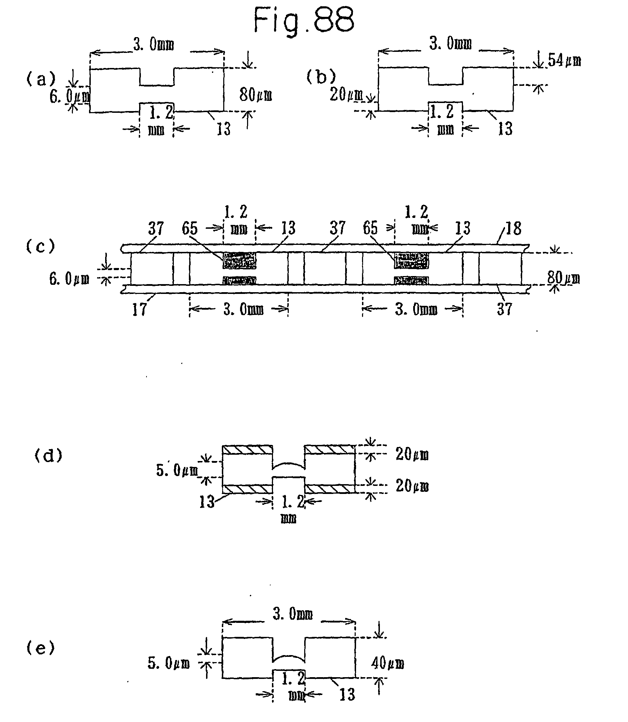

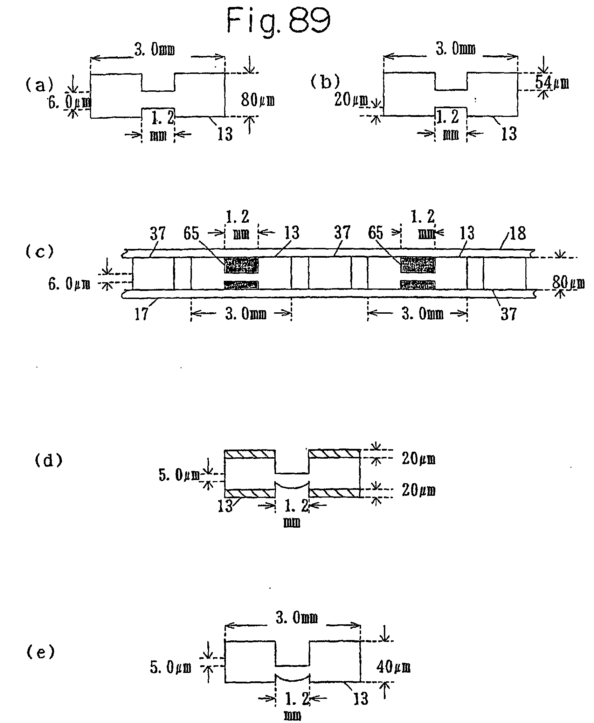

Figure 88 and Figure 89 show the lapping state of the quartz plate 13, which double inverted mesa type plate is machined by the dual face lapping machine, after the plate is shaped to be concave by the wet etching or other RIE processes.

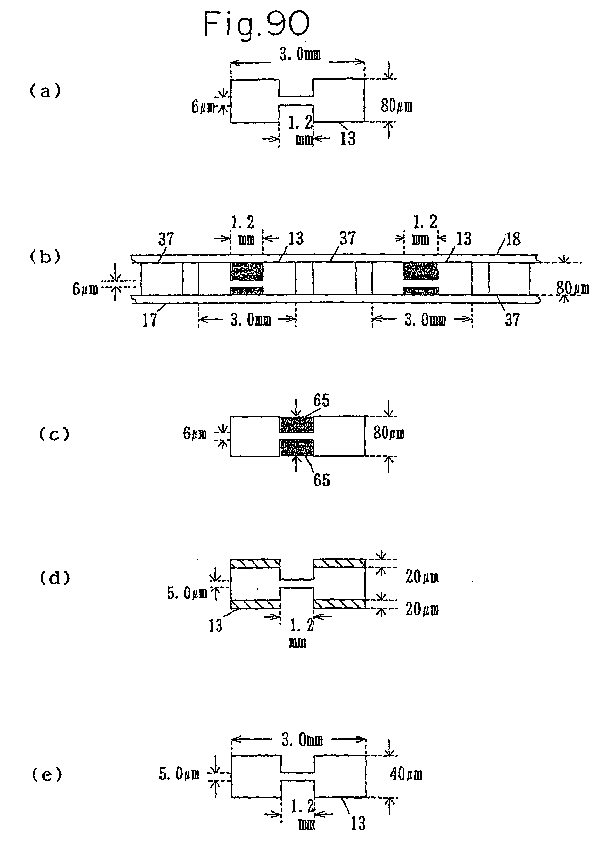

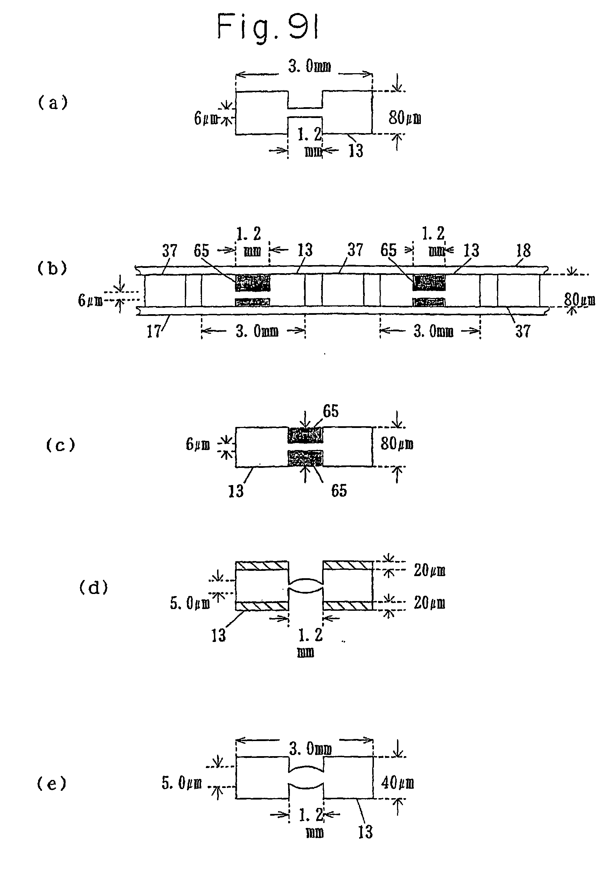

As shown in Figures 88, 89, 90 and 91, when the quartz plate 13 is etched chemically and machined by the dual face lapping machine, the plate becomes naturally convex or concave as seen in Figures 88 (e), 89 (e) and 91 (e), since the force to the lower lapping plate over the upper one is 55/45.

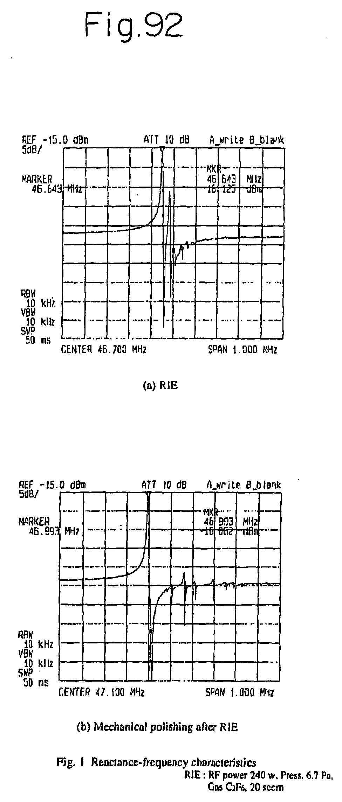

Figure 92 (a) shows an example of reactance-frequency characteristics for the quartz resonator, which is made by so-called dry etching process as RIE, ion milling or plasma etching. Near the peak fundamental frequency there is a spurious peak possibly due to RIE ion damage. After the surface is lapped manually, the spurious peak disappears as shown in Figure 92 (b), and the property improves.

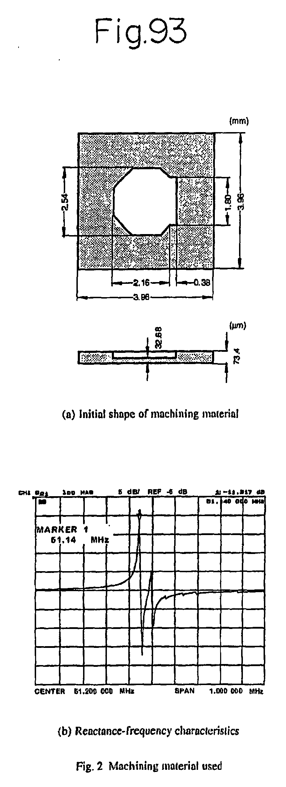

Figure 93 shows the quartz oscillator of single inverted mesa type, which quartz wafer is masked and etched chemically for the mass production of quartz blank. As seen in Figure 93 (b), the reactance-frequency property is similar to RIE in Figure 1 (a).

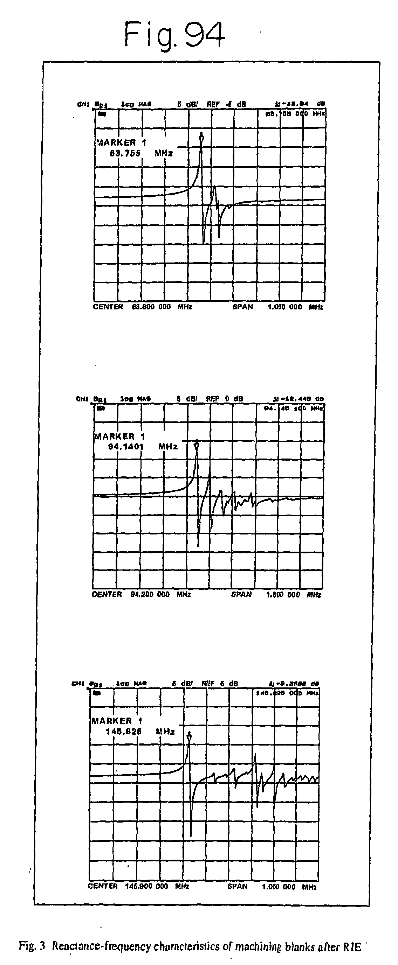

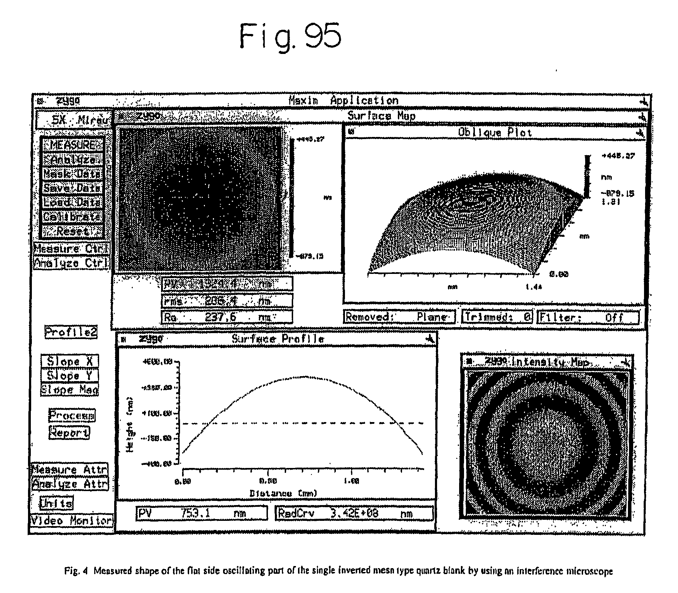

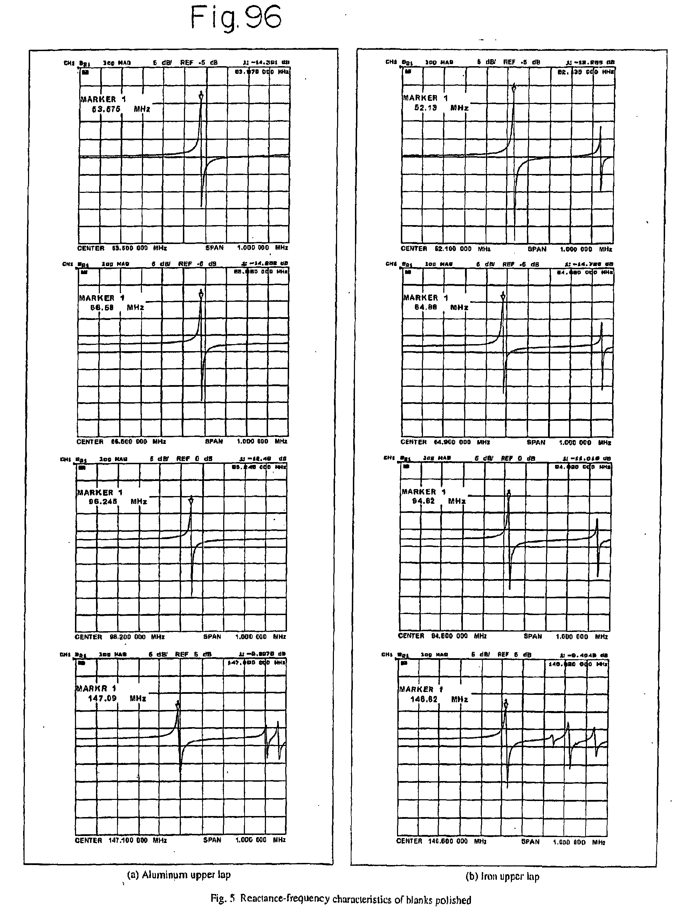

Figure 94 shows the reactance-frequency property of thin high frequency quartz oscillator in the single mesa shape, which is made by RIE and mechanical polishing with the dual face lapping machine. Figure 95 shows the property of the single mesa type quartz oscillator, which is made by the dual face lapping machine of two different upper lapping plate. The ratio of the load for the upper lapping plate of iron is 1.8 times of aluminum. Figure 96 shows the reactance-frequency property of quartz resonator, which has four lapping materials and two lapping pressures. The stronger the pressure is, the sharper the resonance is, however the spurious resonance is observed. There is the optimum pressure and aperture/thickness ratio.

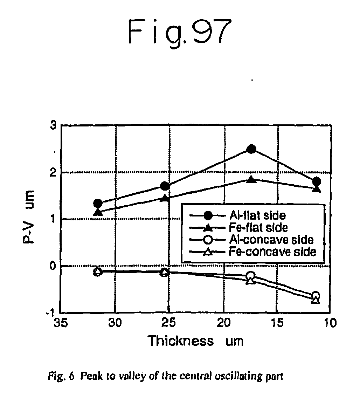

Figure 97 shows the peak to valley (P-V) at 1.44x1.31 mm central part in order to study the effect of the resonating thickness to the form and surface thickness.

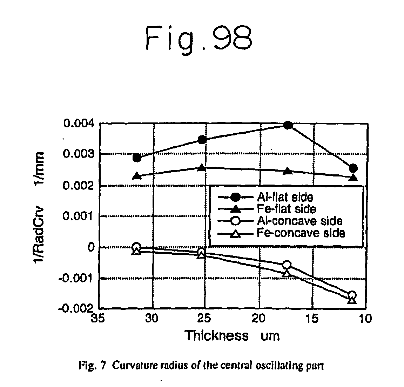

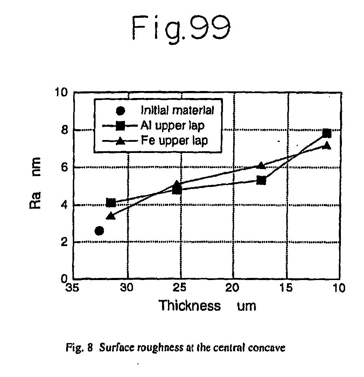

Figure 98 shows the inverse of curvature radius for the convex lens. Figure 99 shows the surface roughness of the concave central part.

These tests result in the conclusion that the optimum diameter to thickness ratio is between 10 and 350 and approximately 80, and that the high frequency quartz resonator over 334 MHz is found to be made to show excellent electric property, as follows.
(1) When quartz blanks of single inverted mesa type is used as the lapped material, quartz oscillators for ultra high frequency applications became feasible to be excellent electrically, after these blanks were machined by the conventional dual face lapping machine, float polishing system or other lapping machines.
(2) These developed machines could make plano-convex type oscillators from single inverted mesa types. Electric characteristics of double inverted mesa types were improved as well as the single types.
(3) The optimum diameter to thickness ratio (d/t) was found to be between 10 and 350, and the typical value of d/t was approximately 80.

In the following section a sound-electric converter is introduced as an application of the piezoelectric element. The conventional prediction of earthquake uses sea observation, underground structure search, global magnetic detection, GPS and ground displacement search of laser distance measurement, however another method may be air vibration sensing. A sound gathering microphone was employed to convert the air vibration to electric signal, which is easy to record and analyze, but it was difficult to detect the sound of the specific frequency due to the noise pickup.

Figure 30 (a)-(e) show five examples of sound-electric converter, which are executed by the piezoelectric element of the present invention. In these Figures piezoelectric cylinders 21 and 54 are made from mono-crystal as quartz or lithium niobate etc. or ceramics as barium titanate and so forth. The central part of the cylinder 21 and 54 has a pressure surface 22, which has a pair of electrodes 23 and 24 connected to an amplifier 25 to measure the induced voltage between the electrodes. Figure 30 (a) (b) (c) (d) and (e) shows the bi-convex, dual concave, plane, round circumferential plane and plano-convex type, respectively. As seen in Figure 30 (a), A room is made by sealing the inside of cylinder 21 with two plugs, and B room is made by sealing the inside of cylinder 54.

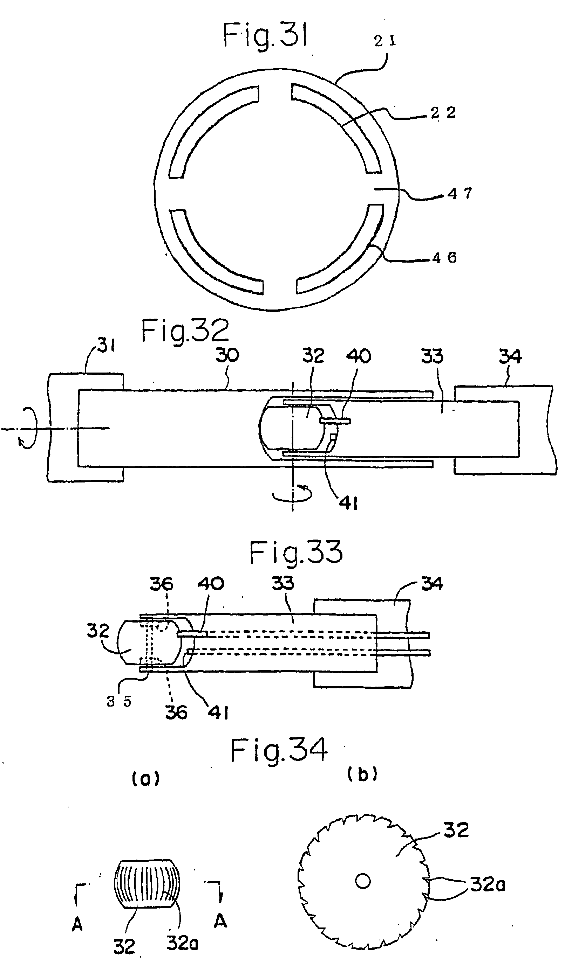

Figure 31 is the upper view diagram of the sound-electric converter in Figure 30 (a) (e), where a hole or space 47 is formed by the pressure sensing surface 22. Then the vibration, which is induced from cylinders 21 and 54, moves freely from A to B or from B to A in Figure 30 (a) (e), the vibrations at A and B resonate at the central part, and the pressure sensor 22 is vibrated more strongly than the case without the hole or space 47.

The pressure sensor 22 is made as follows. Basically as shown in Figure 32, it hold a circle stick 30 with the zipper 31 of the processing machine such as a lathe, and hold the processing tool 33 that rotation set up the whetstone 32 which made a diamond whetstone grain stick to the surface of the metal ball again in the tip freely with the tool holder 34. The whetstone 32 is the sphere body that a confrontation side was cut as shown in Figure 33, and it is gaining rotation freely with it through the shaft carrier 36 at the tip of the support arm 35. As seen in Figure 34, it has the direction that a V letter-shaped groove 32a is contained in the form groove 32a wall one side whetstone 32 center pass side. Another application of the above lapping process is shown in Figures 2, 3 and 4 by using a whetstone 32 in Figure 36 (e).

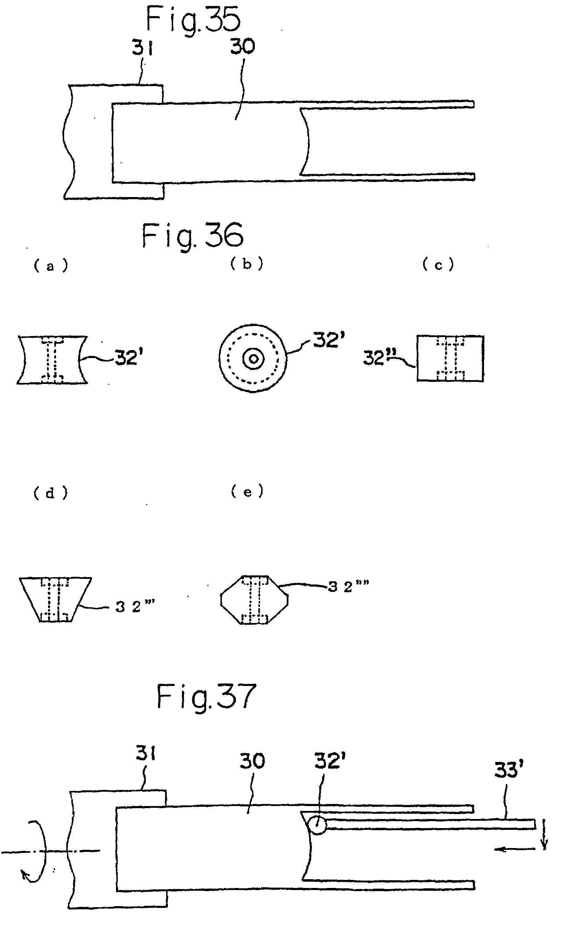

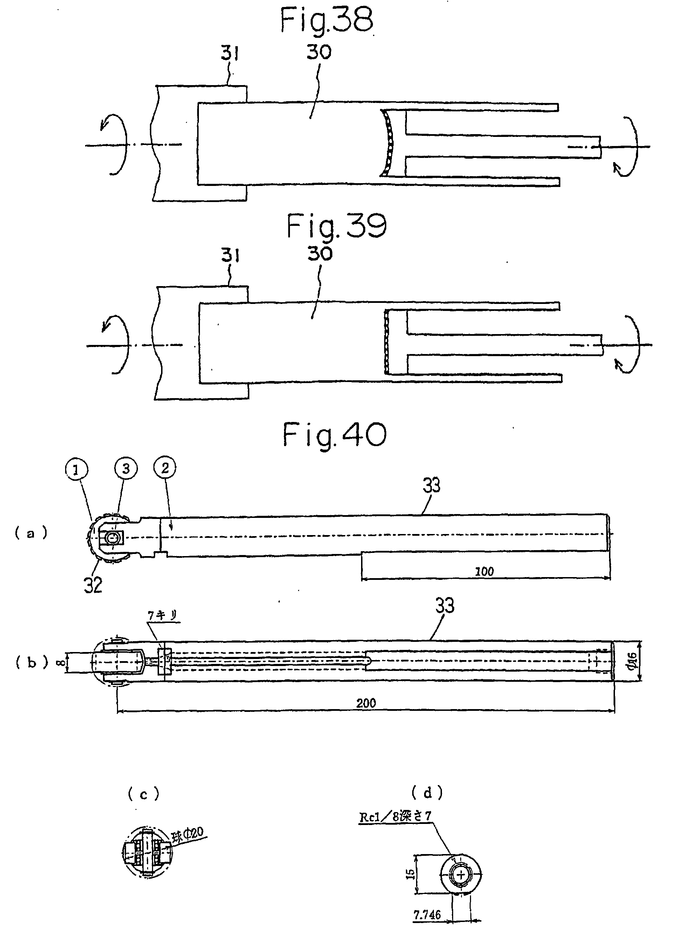

The whetstone 32 of the much smaller diameter from the hole diameter is used as shown in Figure 37, and it turns a whetstone 32 with going along the tune side of the pressure side 22 with the NC device and so on and moving it. The tool to turn around the usual shaft can be used for processing of the hole of the circle form, and the whetstone of the circular board surface form shown in the whetstone of the spherical surface form shown in Figure 38 and 39 can be also used.

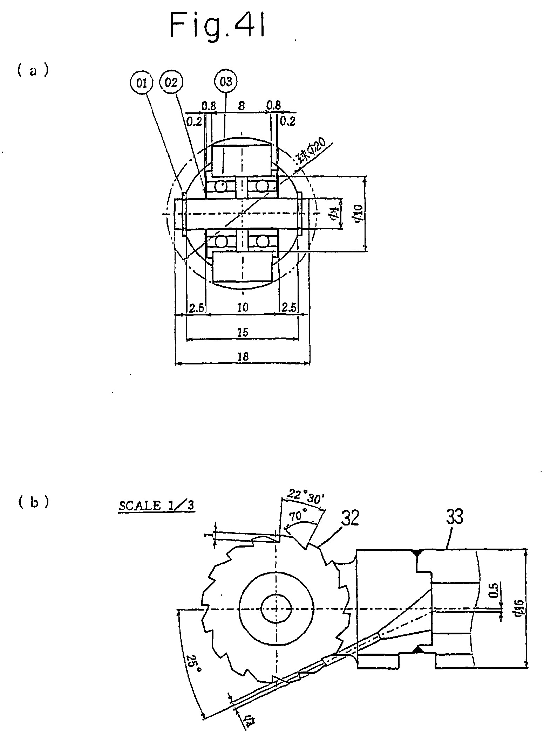

And it is the production figure of the grinding device to show it in the figure 40 and 41, which has structure to show in Figure 33. When the diameter of the whetstone 32 is 20 mm and the depth of the groove 32 (a) is 1 mm, it faces on one side of the whetstone 32, and the number of the actual measurement value that the number of the rotation of the whetstone 32 was measured with the air pressure when it was jetted in the tangent direction is shown to grinding and a grinding device in the following from the air nozzle 40.
1. The rotation of the whetstone 32 is approximately 12,200 rpm, when the air pressure is 0.5 atmosphere.
2. The rotation of the whetstone 32 is approximately 22,000 rpm, when the air pressure is 1.0 atmosphere.
3. The rotation of the whetstone 32 is approximately 37,500 rpm, when the air pressure is 2.0 atmosphere.
4. The rotation of the whetstone 32 is approximately 47,800 rpm, when the air pressure is 3.0 atmosphere.
5. The rotation of the whetstone 32 is approximately 50,000 rpm which is the limiting case of the bearing, when the air pressure is 4.0 atmosphere.

### Effect of Invention

The present invention of the piezoelectric element has the following effects.
1. High frequency quartz oscillators for example, which have an excellent electrical characteristics, become possible to be manufactured from the quartz blank by the conventional dual-face lapping machine, single-face lapping machine or float polishing machine.
2. The present invention enables the single inverted mesa type shape to be the piano-convex type. Also the electrical performance of the double inverted mesa type shows same improvement as the single inverted mesa type.
3. The Quartz oscillator over 334 MHz becomes available when the aperture ratio of the diameter to the depth is approximately 80.

As mentioned above, the present invention makes the piezoelectric element to be extremely thin as less than 10 µm and to show practically no spurious signals.

### Industrial Applicability

The present invention can be applied to a wide variety of fundamental oscillation sources for communication instruments and detection instruments, and micro clock generators for general computers, OA information technology and other instrumentations.

## Claims

1. An arbitrary shape piezoelectric element comprising a planer concave part at one central oscillating surface and a convex-lens-shape convex part at another central surface.

2. An arbitrary shape piezoelectric element comprising a concave-lens-shape concave part at one central oscillating surface and a convex-lens-shape convex part at another central surface.

3. An arbitrary shape piezoelectric element comprising a convex-lens-shape concave part at one central oscillating surface and a convex-lens-shape convex part at another central surface.

4. An arbitrary shape piezoelectric element comprising a concave-lens-shape concave part at one central oscillating surface and a convex-lens-shape concave part at another central surface.

5. An arbitrary shape piezoelectric element comprising a convex-lens-shape concave part at one central oscillating surface and a plane-lens-shape concave part at another central surface.

6. An arbitrary shape piezoelectric element comprising a convex-lens-shape concave part at one central oscillating surface and a convex-lens-shape concave part at another central surface.

7. Manufacturing method for a piezoelectric element featuring the mechanical dual-face lapping of said piezoelectric blank and the polishing of said surface small roughness due to the chemical etching, after one surface or both surfaces of said piezoelectric element which are machined by the mechanical lapping process are chemically etched and become thinner.

8. Manufacturing method for said extremely thin piezoelectric element featuring the manufacturing process of said element by forming grooves and steps on the upper surface of the first auxiliary lapping tool, by connecting the second auxiliary lapping tool which is slightly higher than the depth of said grooves or steps into the grooves or steps of said first auxiliary lapping tool, by setting said piezoelectric blank on the upper surface of said first auxiliary lapping too] inside said second auxiliary lapping tool, and by lapping said blank with the upper lapping plate on said piezoelectric blank and with the lower lapping plate under said auxiliary lapping tool.

9. Manufacturing method for said piezoelectric element as in claim 8 featuring the process of filling liquid in said grooves or steps on said first auxiliary lapping tool surface, setting said piezoelectric blank so as to contact the lower surface of said piezoelectric blank to said liquid, and fixing said blank to said first auxiliary lapping tool by said liquid surface tension or by freezing.

10. Manufacturing method for said piezoelectric element as in claim 9 featuring to set said piezoelectric blank on a thin wet plate with water, and fixing said blank to said first auxiliary lapping tool by using said water surface tension of said thin wet plate.

11. Manufacturing method for said piezoelectric element as in claim 8 featuring making plural holes on said first auxiliary lapping tool, filling viscous material as adhesive into said holes, and fixing said blank to said first auxiliary lapping tool by connecting the lower surface of said piezoelectric blank to said viscous material or by vacuum force.

12. Manufacturing method for said piezoelectric element as in claim 8 featuring to fix said blank to said first auxiliary lapping tool by using pine resin, paraffin, starch paste or other adhesives.

13. Manufacturing method for said piezoelectric element as in any of claim 8 to 12 featuring to use hard glass or metal as super steel as material of said first auxiliary lapping tool, and to use super steel, iron, hard glass or other glasses as material of said second auxiliary lapping tool.

14. Manufacturing method for said piezoelectric element featuring to make a concave part by chemical etching on one surface of said piezoelectric blank, to make thin the base surface of said concave side by ion etching of the opposite surface of said concave side, to lap mechanically both surfaces of said piezoelectric blank, to eliminate the roughness due to said ion etching process, and to form convex-lens shape oscillating part in said concave part.

15. Manufacturing method for said piezoelectric element of the previous claim 14 featuring to make a concave part by RIE process, ion milling plasma etching or other wet etching means only on the central part, after masking said piezoelectric blank one surface by the mask.

16. Manufacturing method for said piezoelectric element featuring to hold said piezoelectric blank on said auxiliary tool, to lap one surface of said piezoelectric blank by one lapping surface of said dual-face lapping machine, to lap at the same time one surface of said auxiliary tool by another lapping surface, and to use said dual-face machine as a single face lapping tool.

17. Manufacturing method for said piezoelectric element featuring to hold the front surface or the rear surface of said piezoelectric blank by said auxiliary lapping tool, and to lap the concave surface of said piezoelectric blank by one lapping surface, and at the same time one surface of said auxiliary lapping tool by another lapping surface of dual-face lapping machine

18. Manufacturing method for said extremely thin piezoelectric element featuring to make the concave part on said piezoelectric blank, to hold said concave part by said auxiliary lapping tool, and to lap the opposite surface of said concave part by one lapping surface and at the same time one surface of said auxiliary lapping tool by another lapping surface by using said dual-face lapping machine.

19. Manufacturing method for said extremely thin piezoelectric element featuring to lap said piezoelectric blank, which surface is concave, concavo-convex or bi-convex, at the same time from the upper side and lower side by using said dual-face lapping machine.

20. Manufacturing method for said piezoelectric element as in claim 19 featuring to fill pine resin, paraffin or other adhesives into the concave pit of said concave piezoelectric blank, and to lap said reinforced concave blank.

21. Manufacturing method for said piezoelectric element as in any of claim 16 to 18 featuring to make said auxiliary lapping from hard glass, plastics or metal as super steel or iron, which is hardly lapped by said lapping material as selenium oxide etc, and not easy to lap the one surface of said auxiliary lapping tool.

22. Manufacturing method for said piezoelectric element, as in claim 14, featuring to make the concave part on said piezoelectric blank, after setting the masking plate of holed quartzite on the piezoelectric blank and making the ion etching machining by using the masking technique.

23. Manufacturing method for said piezoelectric element, as in claim 14, featuring to higher the surface lapping accuracy of quartz and so on by using Argon mixed with fluorine gas as CF4, CHF3 or C2H8 etc, when the piezoelectric material as quartz and so forth is ion-etched.

24. Manufacturing method for said piezoelectric element, featuring to make electrodes to impress the electric voltage on the piezoelectric element after connecting fine gold wires to the central part of said piezoelectric plate.

25. Manufacturing method for very thin piezoelectric element, featuring to make the concave part on said piezoelectric blank, after lapping at the same time both surfaces of said piezoelectric blank, which one surface is flat and another side is concave, by using said dual-face lapping machine.

26. Manufacturing method for said piezoelectric element featuring to lap at the same time both surfaces of said piezoelectric blank, which one surface is stil flat and another side is concave, by using said dual-face lapping machine, and to make outer a convex lens shape of plano-convex, concavo-convex or bi-convex at the front side.

27. Manufacturing method for said piezoelectric element featuring to only to lap one surface of said piezoelectric blank by one surface of said dual-face lapping machine after putting said blank naturally on said auxiliary lapping tool made from metal or other material or pasting said blank by adhesives as pine resin, paraffin or others, and also to lap the rear surface of said auxiliary lapping tool by anther surface, and to make plano-convex type, concavo-convex type or bi-convex type by lapping the rear surface of said blank.

28. Manufacturing method for said piezoelectric element featuring to only to put said concave piezoelectric blank on said auxiliary lapping tool with vertical holes, or to paste by adhesives as pine resin or paraffin etc., and to lap one surface of said dual-face lapping machine after putting said blank naturally on said auxiliary lapping tool made from metal or other material, and also to lap the rear surface of said auxiliary lapping tool by anther surface, and to make plano-convex type, concavo-convex type or bi-convex type by lapping the rear surface of said blank.

29. Manufacturing method for said piezoelectric element featuring to lap the damaged layer, which is produced during the conventional wet etching and RIE processes, by mechanical lapping process, after said mechanically lapped piezoelectric blank is made to be extremely thin by said chemical and ion etchings.

30. Manufacturing method for said piezoelectric element, featuring to lap said blank so that one surface is in concave lens shape and another side is protruding as convex lens.

31. Manufacturing method for said piezoelectric element featuring that one surface is in concave lens shape and another side is protruding as convex lens which convex part is only made to be imminent from the flat plate.

32. Manufacturing method for said piezoelectric element featuring that the ratio of the diameter to the depth is from 10 to 350, or preferentially from 30 to 150 for said element.

33. Manufacturing method for said piezoelectric element, featuring to make the perpendicular and horizontal central lines unchanged to the tool holder for any diameters of diamond whetstone grains, by using the ball whetstone which diamond grains are not solely electrically gilt to the touching part of the tool holder, when the ball whetstone is set to the cylindrical tool holder by the magnetic induction of magnet in cylindrical shape etc of the primary axis.

34. Sound to electric converter, featuring to make pressure sensing surface of piezoelectric effect material at the central part and to set a pair of electrodes at said surface.

35. Sound to electric converter, as in claim 34, featuring to make pressure sensing surface of piezoelectric effect material together to the cylinder.

36. Sound to electric converter, as in claim 34 or 35, featuring to make the central pressure sensing surface vibrate intensively, after forming holes or space at the circumferential part of the pressuring surface in order to resonate the air oscillation when the sound comes into both sides of the cylinder towards said pressuring surface.

37. Manufacturing method of sound to electric converter, featuring to make cylindrical hole into both sides of circular piezoelectric rod by milling method, to make the pressure sensing surface of required thickness at the center of said rod, and to set a pair of electrodes at the pressure outer surface in order to get the electric signal amplified from the environmental air oscillation.

38. Machining method of piezoelectric effect material, as in claim 37, featuring to make grains on the barrel surface of whetstone, to inject air or liquid to the grains, and rotate said whetstone, as the machining means, or to use other mechanical techniques.

39. Manufacturing method for said sound to electric converter, as in claims37 and 38, featuring to make barrel whetstone by using steel sphere in a genuine circular cross section.

40. Manufacturing system for said sound to electric converter, featuring no only to include the machine to fix one end of piezoelectric circular rod and to rotate around the rod axis line, but also to use the machining tool, of which end has the driving mechanism to rotate said whetstone in barrel shape in high speed.
